# EUROPEAN PATENT APPLICATION

(11) **EP 4 135 045 A1**
(43) Date of publication of application: **15.02.2023**
(21) Application number: 21930748.5
(22) Date of filing: 16.03.2021
(51) Int. Cl.: H01L 27/32

(54) **DISPLAY PANEL, MANUFACTURING METHOD THEREFOR, AND DISPLAY APPARATUS**

(71) Applicant: BOE Technology Group Co., Ltd., Beijing 100015 (CN); Chengdu BOE Optoelectronics Technology Co., Ltd., Chengdu, Sichuan 611731 (CN)
(72) Inventor: WANG, Tsanghong, Beijing 100176 (CN); HUANG, Hsinwei, Beijing 100176 (CN); LI, Chunyang, Beijing 100176 (CN); ZHANG, Kai, Beijing 100176 (CN); WU, Jianpeng, Beijing 100176 (CN)
(74) Representative: Brötz, Helmut
(86) International application number: PCT/CN2021/081173
(87) International publication number: WO 2022/193152

(57) **Abstract**

A display panel (10), a manufacturing method therefor, and a display apparatus (100). The display panel comprises a base substrate (1), wherein multiple sub-pixels (11/12/13) are arranged on the base substrate (1), and at least some sub-pixels (11/12/13) among the multiple sub-pixels (11/12/13) comprise a light-emitting layer; at least two consecutively arranged sub-pixels (11/12/13) in the multiple sub-pixels (11/12/13) form a sub-pixel group (31/32/33), and in each sub-pixel group (31/32/33) of the at least some sub-pixel groups (31/32/33), light-emitting layers of the at least two consecutively arranged sub-pixels (11/12/13) are of the same material and are of an integrated structure; and the at least some sub-pixel groups (31/32/33) comprise at least two sub-pixel groups (31/32/33) that respectively emit light of different colors. The display panel (10) can reduce the area of a non-light-emitting region, and PPI and an aperture ratio of the display panel are improved.

## Description

### TECHNICAL FIELD

At least one embodiment of the present disclosure relates to a display panel and a manufacturing method thereof, and a display device.

### BACKGROUND

At present, high PPI (Pixels Per Inch, characterizing pixel density) display is a development direction of display technology, for an active-matrix organic light emitting diode (AMOLED) light-emitting display, a high-density pixel arrangement increases difficulty of an evaporation process of a pixel array, the process limit limits a further improvement of PPI. At the same time, in the display panel, generally, as the pixel arrangement increases with the increase of the PPI, the aperture ratio will be significantly reduced, and at the same time, the service life of the display panel will also be reduced.

### SUMMARY

At least one embodiment of the present disclosure provides a display panel, the display panel includes a base substrate, a plurality of sub-pixels are arranged on the base substrate, at least part of the plurality of sub-pixels comprises a light-emitting layer; at least two sub-pixels consecutively arranged among the plurality of sub-pixels constitute one sub-pixel group, in each sub-pixel group of at least part of the sub-pixel groups, the light-emitting layers of at least two consecutively arranged sub-pixels are made of a same material and constitute an integral structure; the at least part of the sub-pixel groups comprises at least two sub-pixel groups that respectively emit light of different colors.

For example, in the display panel provided by at least one embodiment of the present disclosure, a plurality of pixels are arranged on the base substrate, each pixel of the plurality of pixels comprises a plurality of the sub-pixels, the plurality of the sub-pixels of one of the pixels comprise: a first sub-pixel, a second sub-pixel and a third sub-pixel. The first sub-pixel comprises a first light-emitting layer, the first light-emitting layer emits a first color light; the second sub-pixel comprises a second light-emitting layer, the second light-emitting layer emits a second color light; and the third sub-pixel comprises a third light-emitting layer, the third light-emitting layer emits a third color light, color of the first color light, color of the second color light and color of the third color light are different from each other, at least two of the first sub-pixels are consecutively arranged to constitute one first sub-pixel group; at least two of the second sub-pixels are consecutively arranged to constitute one second sub-pixel group; at least two of the third sub-pixels are consecutively arranged to constitute one third sub-pixel group; and the at least part of the sub-pixel groups comprises at least two selected from a group consisting of the first sub-pixel group, the second sub-pixel group, and the third sub-pixel group.

For example, in the display panel provided by at least one embodiment of the present disclosure, in each first sub-pixel group of at least part of the first sub-pixel groups, the first light-emitting layers of the first sub-pixels that are consecutively arranged constitute an integral structure; in each second sub-pixel group of at least part of the second sub-pixel groups, the second light-emitting layers of the second sub-pixels that are consecutively arranged constitute an integral structure; and in each third sub-pixel group of at least part of the third sub-pixel groups, the third light-emitting layers of the third sub-pixels that are consecutively arranged constitute an integral structure.

For example, in the display panel provided by at least one embodiment of the present disclosure, in each first sub-pixel group of the at least part of the first sub-pixel groups, a planar shape of the integral structure constituted by the first light-emitting layers of the two consecutively arranged first sub-pixels is one selected from a group consisting of a hexagon, an octagon, an ellipse, a rhombus, and a fusiform; and/or in each third sub-pixel group of the at least part of the third sub-pixel groups, a planar shape of the integral structure constituted by the third light-emitting layers of the two consecutively arranged third sub-pixels is one selected from the group consisting of a hexagon, an octagon, an ellipse, a rhombus, and a fusiform.

For example, in the display panel provided by at least one embodiment of the present disclosure, in each first sub-pixel group of at least part of the first sub-pixel groups, the first light-emitting layers of the first sub-pixels that are consecutively arranged constitute an integral structure; in each second sub-pixel group of at least part of the second sub-pixel groups, the second light-emitting layers of the second sub-pixels that are consecutively arranged do not constitute an integral structure; and in each third sub-pixel group of at least part of the third sub-pixel groups, the third light-emitting layers of the third sub-pixels that are consecutively arranged constitute an integral structure.

For example, in the display panel provided by at least one embodiment of the present disclosure, an area of the second light-emitting layer of the second sub-pixel is greater than an area of the first light-emitting layer of the first sub-pixel, and is greater than an area of the third light-emitting layer of the third sub-pixel.

For example, in the display panel provided by at least one embodiment of the present disclosure, a shorter bottom edge of the first light-emitting layer of the first sub-pixel and a shorter bottom edge of the third light-emitting layer of the third sub-pixel that is adjacent to the first sub-pixel are close to each other and opposite to each other.

For example, the display panel provided by at least one embodiment of the present disclosure further comprises a pixel definition layer, the pixel definition layer comprises a plurality of openings and a main body defining the plurality of openings, the plurality of openings are in one-to-one correspondence with the plurality of sub-pixels; in each sub-pixel group of the at least part of the sub-pixel groups, the light-emitting layer of each of the sub-pixels comprises an effective part in the corresponding opening among the openings of the pixel definition layer, and an edge part on the main body of the pixel definition layer.

For example, in the display panel provided by at least one embodiment of the present disclosure, a first distance between edges of effective parts of two consecutively arranged first sub-pixels in each of the first sub-pixel groups that are close to each other and opposite to each other, a second distance between edges of effective parts of two consecutively arranged second sub-pixels in each second sub-pixel groups that are close to each other and opposite to each other, and a third distance between edges of effective parts of two consecutively arranged third sub-pixels in each of the third sub-pixel groups that are close to each other and opposite to each other are basically equal.

For example, in the display panel provided by at least one embodiment of the present disclosure, the first distance, the second distance, and the third distance are respectively less than or equal to 8 µm.

For example, in the display panel provided by at least one embodiment of the present disclosure, a planar shape of the effective part of the first sub-pixel, a planar shape of the effective part of the second sub-pixel, and a planar shape of the effective part of the third sub-pixel are respectively consistent with an planar shape of the entire first light-emitting layer, an planar shape of the entire second light-emitting layer, and an planar shape of the entire third light-emitting layer.

For example, in the display panel provided by at least one embodiment of the present disclosure, in each of the at least part of the first sub-pixel groups, a planar shape of each effective part of the consecutively arranged first sub-pixels is a trapezoid, and longer bottom edges of the effective parts of the two consecutively arranged first light-emitting layers are close to each other and opposite to each other; and/or in each of the at least part of the third sub-pixel groups, a planar shape of each effective part of the consecutively arranged third sub-pixels is a trapezoid, and longer bottom edges of the effective parts of the two consecutively arranged third light-emitting layers are close to each other and opposite to each other.

For example, in the display panel provided by at least one embodiment of the present disclosure, a planar shape of the effective part of the first light-emitting layer, a planar shape of the effective part of the second light-emitting layer, and a planar shape of the effective part of the third light-emitting layer are all rectangular.

For example, in the display panel provided by at least one embodiment of the present disclosure, in each sub-pixel group of the at least part of the sub-pixel groups, edges of the effective part are in one-to-one correspondence with edges of an outer contour of the edge part, each pair of mutually corresponding edges of the effective part and the outer contour of the edge part are close to and opposite to each other, and a distance between each pair of mutually corresponding edges of the effective part and the outer contour of the edge part is less than or equal to 9 µm.

For example, in the display panel provided by at least one embodiment of the present disclosure, in the first sub-pixel, in the second sub-pixel, and in the third sub-pixel, distances between each pair of mutually corresponding edges of the effective part and the outer contour of the edge part are same.

For example, in the display panel provided by at least one embodiment of the present disclosure, a pixel array comprises a plurality of sub-pixel rows extending in a first direction, a plurality of first sub-pixel columns extending in a second direction, and a plurality of second sub-pixel columns extending in the second direction, each of the second sub-pixel columns is between the consecutively arranged first sub-pixel columns, the second direction intersects the first direction; in each of the first sub-pixel columns, the first sub-pixel groups and the third sub-pixel groups are alternately arranged; in each of the second sub-pixel columns, a plurality of the second sub-pixel groups are arranged in sequence; and the second light-emitting layer of one of the second sub-pixel groups and the second light-emitting layer of another one of the second sub-pixel groups consecutively arranged with the one of the second sub-pixel groups in the second sub-pixel column do not constitute an integral structure.

For example, in the display panel provided by at least one embodiment of the present disclosure, a gap is between the second light-emitting layer of the one of the second sub-pixel groups and the second light-emitting layer of the another one of the second sub-pixel groups consecutively arranged with the one of the second sub-pixel groups; and a distance between two adjacent effective parts in the second light-emitting layers constituting the integral structure in the second sub-pixel group is smaller than a distance between the effective parts of, two adjacent second light-emitting layers that are spaced apart by the gap between each other.

For example, in the display panel provided by at least one embodiment of the present disclosure, a ratio of an area of the effective part of each of the first sub-pixels to an area of an entirety of the light-emitting layer of each of the first sub-pixels is 17%; a ratio of an area of the effective part of each of the second sub-pixels to an area of an entirety of the light-emitting layer of each of the second sub-pixels is 21%; and a ratio of an area of the effective part of each of the third sub-pixels to an area of an entirety of the light-emitting layer of each of the third sub-pixels is 30%.

For example, in the display panel provided by at least one embodiment of the present disclosure, one of the first sub-pixels and one of the third sub-pixels adjacent to each other in one of the first sub-pixel columns, and one of the second sub-pixels in the second sub-pixel column adjacent to the one of the first sub-pixel columns constitute one pixel; or, one of the first sub-pixels, one of the second sub-pixels, and one of the third sub-pixels that are respectively located in the first sub-pixel group, the second sub-pixel group and the third sub-pixel group that are consecutively arranged in the first direction constitute one pixel.

For example, in the display panel provided by at least one embodiment of the present disclosure, the plurality of pixels are arranged periodically in the first direction and the second direction, respectively; in one of the pixels, the first sub-pixel, the second sub-pixel, and the third sub-pixel are not aligned in the second direction, and an edge of the second sub-pixel close to the first sub-pixel and the third sub-pixel overlaps with both an edge of the first sub-pixel and an edge of the third sub-pixel that are close to the second sub-pixel.

For example, in the display panel provided by at least one embodiment of the present disclosure, a plurality of the second sub-pixels in a same row overlap in the second direction, and a plurality of second sub-pixels located in a same column overlap in the first direction.

For example, in the display panel provided by at least one embodiment of the present disclosure, an included angle is with between a direction, of a longest dimension of the effective part of at least one selected from a group consisting of the first sub-pixel, the second sub-pixel, and the third sub-pixel, and the first direction or the second direction, and the included angle is greater than 0 and less than or equal to 45 degrees.

For example, in the display panel provided by at least one embodiment of the present disclosure, a length of the effective part of the second sub-pixel in the second direction is greater than a length of the effective part of the first sub-pixel in the second direction, and is greater than a length of the effective part of the third sub-pixel in the second direction.

For example, in the display panel provided by at least one embodiment of the present disclosure, in each of the first sub-pixel groups, the effective parts of the first light-emitting layers of the two consecutively arranged first sub-pixels are symmetrical with respect to a first symmetry axis extending along the first direction; and/or in each of the second sub-pixel groups, the effective parts of the second light-emitting layers of the two consecutively arranged second sub-pixels are symmetrical with respect to a second symmetry axis extending along the first direction; and / or in each of the third sub-pixel groups, the effective parts of the third light-emitting layers of the two consecutively arranged third sub-pixels are symmetrical with respect to a third symmetry axis extending along the first direction.

For example, in the display panel provided by at least one embodiment of the present disclosure, geometric centers of planar shapes of the first sub-pixel group, the second sub-pixel group, and the third sub-pixel group that are arranged in the first direction and located in a same row are substantially located on a same straight line extending along the first direction.

For example, in the display panel provided by at least one embodiment of the present disclosure, in each of the first sub-pixel groups, the effective part of each of the first sub-pixels comprises a near edge close to the first symmetry axis and a far edge away from the first symmetry axis, a length of the near edge of the effective part of each of the first sub-pixels is greater than a length of the far edge of each of the first sub-pixels; and/or in each of the third sub-pixel groups, the effective part of each of the third sub-pixels comprises a near edge close to the third symmetry axis and a far edge away from the third symmetry axis, and a length of the near edge of the effective part of each of the third sub-pixels is greater than a length of the far edge of the effective part of each of the third sub-pixels.

For example, in the display panel provided by at least one embodiment of the present disclosure, at least two selected from a group consisting of a distance from the near edge of the effective part of each of the first sub-pixels of each of the first sub-pixel groups to the second symmetry axis, a distance from the near edge of the effective part of each of the second sub-pixels of each of the second sub-pixel groups to the second symmetry axis, and a distance from the near edge of the effective part of each of the third sub-pixels of each of the third sub-pixel groups to the third symmetry axis are substantially equal.

For example, in the display panel provided by at least one embodiment of the present disclosure, the first direction is a width direction of each of the sub-pixels, the effective part of each of the second sub-pixels is provided with a first width, a second width, and a third width that are sequentially away from the second symmetry axis in the first direction, the second width is greater than the first width, and the third width is greater than the first width.

For example, in the display panel provided by at least one embodiment of the present disclosure, the first direction is a width direction of each of the sub-pixels, the second direction is a length direction of each of the sub-pixels; in one of the pixels, a ratio of a length of the effective part of the second sub-pixel in the length direction to a width of the effective part of the second sub-pixel in the width direction is greater than a ratio of a length of the effective part of the third sub-pixel in the length direction to a width of the effective part of the third sub-pixel in the width direction, and is greater than a ratio of a length of the effective part of the first sub-pixel in the length direction to a width of the effective part of the first sub-pixel in the width direction.

For example, in the display panel provided by at least one embodiment of the present disclosure, the width of the effective part of the second sub-pixel in the width direction is smaller than the width of the effective part of the first sub-pixel in the width direction, and is smaller than the width of the effective part of the third sub-pixel in the width direction.

For example, in the display panel provided by at least one embodiment of the present disclosure, a length of the second sub-pixel in the length direction is greater than a length of the first sub-pixel in the length direction, and is greater than a length of the third sub-pixel in the length direction.

For example, in the display panel provided by at least one embodiment of the present disclosure, the ratio of the length of the effective part of the first sub-pixel to the width of the effective part of the first sub-pixel ranges from 1:2.5 to 1:1, the ratio of the length of the effective part of the second sub-pixel to the width of the effective part of the second sub-pixel ranges from 9:1 to 2:1, and the ratio of the length of the effective part of the third sub-pixel to the width of the effective part of the third sub-pixel ranges from 3: 1 to 1: 1.

For example, in the display panel provided by at least one embodiment of the present disclosure, a planar shape of the effective part of the second light-emitting layer is a polygon, a planar shape of the effective part of the second light-emitting layer comprises a first parallel edge and a second parallel edge, the first parallel edge is parallel to at least one edge of the effective part of the first light-emitting layer adjacent to the second light-emitting layer, and the second parallel edge is parallel to at least one edge of the effective part of the third light-emitting layer adjacent to the second light-emitting layer.

For example, in the display panel provided by at least one embodiment of the present disclosure, the effective part of the second light-emitting layer has a symmetry axis in a same direction as a symmetry axis of the effective part of the first light-emitting layer and a symmetry axis of the effective part of the third light-emitting layer, or the effective part of the second light-emitting layer does not have a symmetry axis in a same direction as a symmetry axis of the effective part of the first light-emitting layer and a symmetry axis of the effective part of the third light-emitting layer.

For example, in the display panel provided by at least one embodiment of the present disclosure, in the first direction, the light-emitting layer of the second sub-pixel group is in contact with the light-emitting layer of the first sub-pixel group and the light-emitting layer of the third sub-pixel group adjacent to the second sub-pixel group respectively; and in the second direction, the light-emitting layer of the first sub-pixel group is in contact with the light-emitting layer of the third sub-pixel group adjacent to the second sub-pixel group.

For example, in the display panel provided by at least one embodiment of the present disclosure, in at least one of the second sub-pixel groups, a planar shape of the integral structure constituted by the second light-emitting layers of two consecutively arranged second sub-pixels has a first size in the first direction, a second size in the first direction, and a third size in the first direction, the first size, the second size, and the third size are arranged in sequence in the second direction, the first size is greater than the second size, the third size is greater than the second size, and a maximum length in the second direction of the planar shape of the integral structure constituted by the second light-emitting layers of the two consecutively arranged second sub-pixels is greater than a maximum width in the first direction of the planar shape of the integral structure constituted by the second light-emitting layers of the two consecutively arranged second sub-pixels.

At least one embodiment of the present disclosure provides a display device, comprising the display panel provided by any one of the embodiments of the present disclosure.

At least one embodiment of the present disclosure provides a manufacturing method of a display panel, comprising: providing a base substrate; and forming a plurality of sub-pixels on the base substrate, in which at least part of the plurality of sub-pixels comprises a light-emitting layer, in which a mask is used to form the light-emitting layers of the plurality of sub-pixels through a patterning process, the mask comprises a plurality of mask openings; at least two sub-pixels arranged consecutively among the plurality of sub-pixels constitute one sub-pixel group, in the patterning process, the light-emitting layer of each sub-pixel group in at least part of the sub-pixel groups is formed by using one same mask opening among the plurality of mask openings and is made of a same material; and the at least part of the sub-pixel groups comprises at least two sub-pixel groups that respectively emit light of different colors.

### BRIEF DESCRIPTION OF THE DRAWINGS

In order to clearly illustrate the technical solution of the embodiments of the present disclosure, the drawings of the embodiments will be briefly described. It is apparent that the described drawings are only related to some embodiments of the present disclosure and thus are not limitative of the present disclosure.
FIG 1A is a schematic structural diagram of a display panel provided by an embodiment of the present disclosure;
FIG 1B is a comparison diagram of the aperture ratio and pixel density of the display panel shown in FIG 1A and the aperture ratio and pixel density of a common display panel;
FIG 2A is a schematic structural diagram of another display panel provided by an embodiment of the present disclosure;
FIG 2B is a first planar schematic diagram of an integral structure constituted by first light-emitting layers of two consecutively arranged first sub-pixels;
FIG 2C is a second planar schematic diagram of an integral structure constituted by first light-emitting layers of two consecutively arranged first sub-pixels;
FIG 2D is a third planar schematic diagram of an integral structure constituted by first light-emitting layers of two consecutively arranged first sub-pixels;
FIG 2E is a forth planar schematic diagram of an integral structure constituted by first light-emitting layers of two consecutively arranged first sub-pixels;
FIG 2F is a planar schematic diagram of an integral structure constituted by second light-emitting layers of two consecutively arranged second sub-pixels;
FIG 3A is a schematic structural diagram of still another display panel provided by an embodiment of the present disclosure;
FIG 3B is a comparison diagram of the aperture ratio and pixel density of the display panel shown in FIG 3A and the aperture ratio and the pixel density of the common display panel;
FIG 4A is a schematic structural diagram of still another display panel provided by an embodiment of the present disclosure;
FIG 4B is a comparison diagram of the aperture ratio and pixel density of the display panel shown in FIG 4A and the aperture ratio and the pixel density of the common display panel;
FIG 5 is a schematic structural diagram of still another display panel provided by an embodiment of the present disclosure;
FIG 6 is a schematic structural diagram of a display panel with a pixel density different from that of the display panel shown in FIG 5 provided by an embodiment of the present disclosure;
FIG 7A is a first schematic diagram of positions of anode holes of the sub-pixels of one pixel;
FIG 7B is a second schematic diagram of positions of anode holes of the sub-pixels of one pixel;
FIG 8 is a schematic diagram of a display device provided by an embodiment of the present disclosure;
FIG 9 is a schematic diagram of a manufacturing method of the display panel using a mask provided by an embodiment of the present disclosure;
FIG 10A is a schematic diagram of an exemplary layer structure of a pixel array; and
FIG 10B is a schematic diagram of another exemplary layer structure of a pixel array.

### DETAILED DESCRIPTION

In order to make objects, technical details and advantages of embodiments of the present disclosure clear, the technical solutions of the embodiments will be described in a clearly and fully understandable way in connection with the related drawings. It is apparent that the described embodiments are just a part but not all of the embodiments of the present disclosure. Based on the described embodiments herein, those skilled in the art can obtain, without any inventive work, other embodiment(s) which should be within the scope of the present disclosure.

Unless otherwise defined, all the technical and scientific terms used herein have the same meanings as commonly understood by one of ordinary skill in the art to which the present disclosure belongs. The terms "first," "second," etc., which are used in the description and claims of the present disclosure, are not intended to indicate any sequence, amount or importance, but distinguish various components. The terms "comprises," "comprising," "includes," "including," etc., are intended to specify that the elements or the objects stated before these terms encompass the elements or the objects listed after these terms as well as equivalents thereof, but do not exclude other elements or objects. The phrases "connect", "connected", etc., are not intended to define a physical connection or a mechanical connection, but may comprise an electrical connection which is direct or indirect. The terms "In," "out," "on," "under" and the like are only used to indicate relative position relationship, and in a case that the position of an object is described as being changed, the relative position relationship may be changed accordingly.

The drawings in the present disclosure are not drawn strictly according to actual scale, a number of pixels in the display panel and a number of sub-pixels in each pixel are not limited to a number shown in the figures, and specific sizes and quantity of each structure can be determined according to actual requirements. The drawings described in the present disclosure are only structural schematic diagrams.

At least one embodiment of the present disclosure provides a display panel, the display panel includes a base substrate, a plurality of sub-pixels are arranged on the base substrate, at least part of the plurality of sub-pixels comprises a light-emitting layer; at least two sub-pixels consecutively arranged among the plurality of sub-pixels constitute one sub-pixel group, in each sub-pixel group of at least part of the sub-pixel groups, the light-emitting layers of at least two consecutively arranged sub-pixels are made of a same material and constitute an integral structure; the at least part of the sub-pixel groups comprises at least two sub-pixel groups that respectively emit light of different colors. The display panel can reduce the area of a non-luminous region, and improve PPI and an aperture ratio of the display panel.

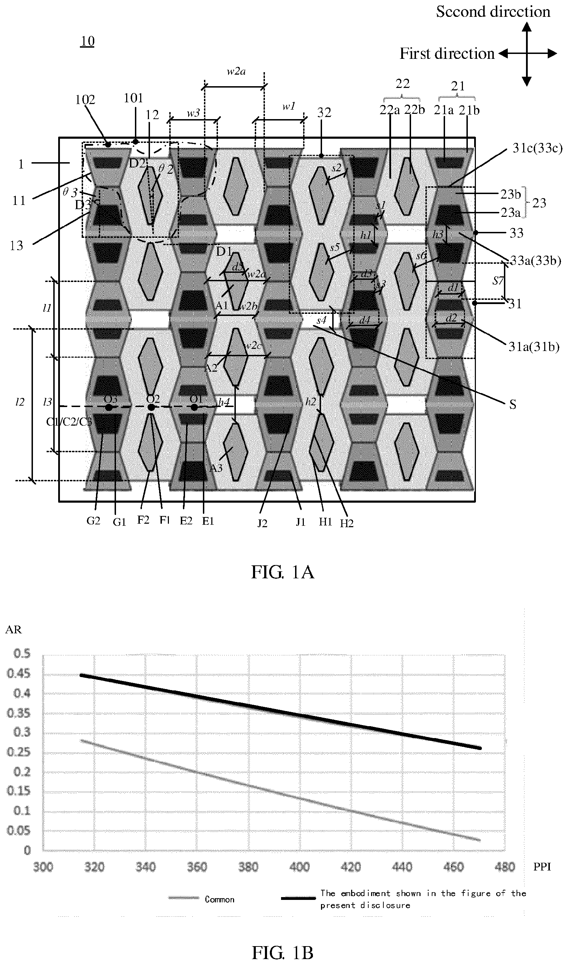

Exemplarily, FIG 1A is a schematic structural diagram of a display panel provided by an embodiment of the present disclosure; and FIG 1B is a comparison diagram of the aperture ratio and pixel density of the display panel shown in FIG 1A and the aperture ratio and pixel density of a common display panel. As shown in FIG 1A, the display panel 10 provided by at least one embodiment of the present disclosure includes a base substrate 1, a plurality of pixels 11 arranged in an array are on the base substrate 1; each of the plurality of pixels 11 includes a plurality of sub-pixels 11/12/13, for example, each of the plurality of sub-pixels 11/12/13 includes a light-emitting element, the light-emitting element includes a light-emitting layer 21/22/23; at least two sub-pixels consecutively arranged among the plurality of sub-pixels 11/12/13 constitute one sub-pixel group 31/32/33, in each sub-pixel group of at least part of (at least some sub-pixel groups of) the sub-pixel groups 31/32/33, materials of the light-emitting layers of at least two consecutive sub-pixels are the same, for example, the light-emitting layers emit light of a same color, and the light-emitting layers of at least two consecutively arranged sub-pixels constitute an integral structure. Therefore, in the process of forming the light-emitting layer through a patterning process such as an evaporation process, the light-emitting layer of the integral structure can be formed by one same opening of a mask. Usually, because process reasons, in the process of forming light-emitting layers of the same color by one patterning process, a gap is between the light-emitting layers of adjacent sub-pixels respectively formed by different openings of the mask, however, no gap exists between the light-emitting layers of at least two consecutively arranged sub-pixels formed by using a same opening of the mask, so that an area of the non-luminous region can be reduced, which is beneficial to increase the PPI and the aperture ratio of the display panel.

For example, the light-emitting element is an electroluminescent device, for example, an organic light-emitting diode (OLED) device.

For example, FIG 1A takes the case that each of the plurality of pixels including three sub-pixels, and two consecutively arranged sub-pixels constitute one sub-pixel group as an example. Specifically, as shown in FIG 1A, a plurality of sub-pixels included in each of the plurality of pixels includes: a first sub-pixel 11, a second sub-pixel 12, and a third sub-pixel 13. The first sub-pixel 11 includes a first light-emitting layer 21, the first light-emitting layer 21 emits a first color light; the second sub-pixel 12 includes a second light-emitting layer 22, the second light-emitting layer 22 emits a second color light; the third sub-pixel 13 includes a third light-emitting layer 23, the third light-emitting layer 23 emits a third color light, and colors of the first color light, the second color light, and the third color light are different from each other. For example, the first light-emitting layer emits red light, the second light-emitting layer emits green light, and the third light-emitting layer emits blue light. For example, two first sub-pixels 11 are consecutively arranged to constitute one first sub-pixel group 31; two second sub-pixels 12 are consecutively arranged to constitute one second sub-pixel group 32; two third sub-pixels 13 are consecutively arranged to constitute one third sub-pixel group 33; and the above-mentioned at least part of the sub-pixel groups include at least one selected from a group consisting of the first sub-pixel group 31, the second sub-pixel group 32, and the third sub-pixel group 33, that is, the above technical effects can be achieved to a certain extent; alternatively, the above-mentioned at least part of the sub-pixel groups include at least two selected from the group consisting of the first sub-pixel group 31, the second sub-pixel group 32, and the third sub-pixel group 33, that is, the above-mentioned at least part of the sub-pixel groups include at least two kinds of sub-pixel groups that respectively emit light of different colors.

For example, as shown in FIG 1A, in at least one embodiment, in each of the at least part of the first sub-pixel groups 31, first light-emitting layers 21 of the consecutively arranged first sub-pixels 11 constitute an integral structure, for example, materials of the first light-emitting layers 21 of two adjacent first sub-pixels 11 in a first sub-pixel group 31 are the same, and no gap or seam is between the first light-emitting layers 21 of two adjacent first sub-pixels 11 in one first sub-pixel group 31, the first light-emitting layers 21 are formed by a same material through one same opening of a mask in one same patterning process, for example, the first light-emitting layers 21 are deposited or evaporated through the same opening of the mask; in each of the at least part of the second sub-pixel groups 32, the second light-emitting layers 22 of consecutively arranged second sub-pixels 12 constitute an integral structure, for example, materials of the second light-emitting layers 22 of two adjacent second sub-pixels 12 in one second sub-pixel group 32 is the same, and no gap or seam is between the second light-emitting layers 22 of two adjacent second sub-pixels 12 in one second sub-pixel group 32, the second light-emitting layers 22 are formed by a same material through one same opening of a mask in one same patterning process, for example, the second light-emitting layers 22 are deposited or evaporated by the same opening of the mask; and in each of at least part of the third sub-pixel groups 33, the third light-emitting layers of consecutively arranged third sub-pixels 14 constitute an integral structure, for example, materials of the third light-emitting layers 23 of two adjacent third sub-pixels 13 in a third sub-pixel group 33 are the same and no gap or seam is between each other, the third light-emitting layers 23 are formed by a same material through one same opening of a mask in one same patterning process, for example, the third light-emitting layers 23 are formed by deposition or evaporation through the same opening of the mask. In this way, for the three types of sub-pixels, the above-mentioned reduction of the area of the non-luminous region can be achieved, and a better effect of improving the PPI and the aperture ratio of the display panel can be achieved. As shown in FIG 1B, under a same PPI condition, the total aperture ratio of the pixels can be increased by 70%, and accordingly, the service life can be increased by more than 13%; with a same aperture ratio, the PPI can be increased by 50%.

It should be noted that, the light-emitting colors of the light-emitting layers of the first sub-pixel, the second sub-pixel, and the third sub-pixel are limited to the red, green, and blue mentioned above, one pixel is not limited to three sub-pixels including the first sub-pixel, the second sub-pixel and the third sub-pixel, for example, the pixel may further include a fourth sub-pixel that emits white light, no limitation is imposed to the kinds of sub-pixels in one pixel in the present disclosure.

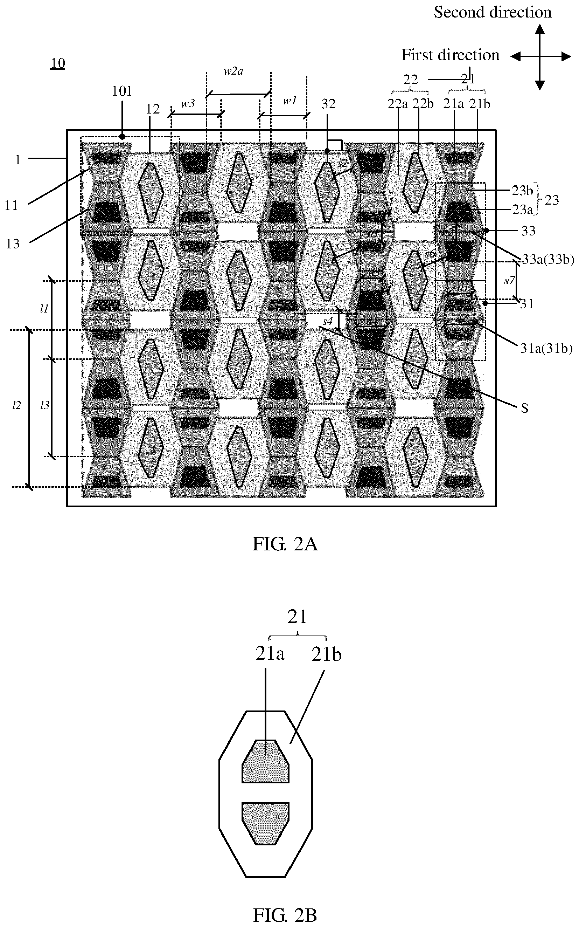

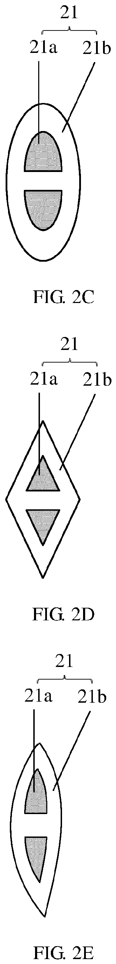

For example, as shown in FIG 1A, in each of at least part of the first sub-pixel groups 31, a planar shape of the integral structure constituted by the first light-emitting layers 21 of the two consecutively arranged first sub-pixels 13 is a hexagon, of course, in some other embodiments, the planar shape of the integrated structure may further be at least one of an octagonal shape such as shown in FIG 2B, an oval shape such as shown in FIG 2C, a diamond shape such as shown in FIG 2D, and a shuttle shape such as shown in FIG 2E. For example, the above-mentioned octagonal shape, oval shape, diamond shape and shuttle shape are respectively axisymmetric figures or not axisymmetric figures; and/or, in each of at least part of the third sub-pixel 33 groups, a planar shape of the integral structure constituted by the third light-emitting layers 23 of the two consecutively arranged third sub-pixels 13 is a hexagon, of course, in some other embodiments, the planar shape of the integral structure can also be at least one of an octagonal shape, an oval shape, a diamond shape, and a shuttle shape. The octagonal shape, oval shape, diamond shape, and shuttle shape can refer to the shapes shown in FIGS. 2B - 2E. Of course, the planar shape of the integral structure constituted by the first light-emitting layer 21 of the two consecutively arranged first sub-pixels 13 and the planar shape of the integral structure constituted by the third light-emitting layers 23 of the two consecutively arranged third sub-pixels 13 are not limited to the types listed above, which can be designed according to specific requirements.

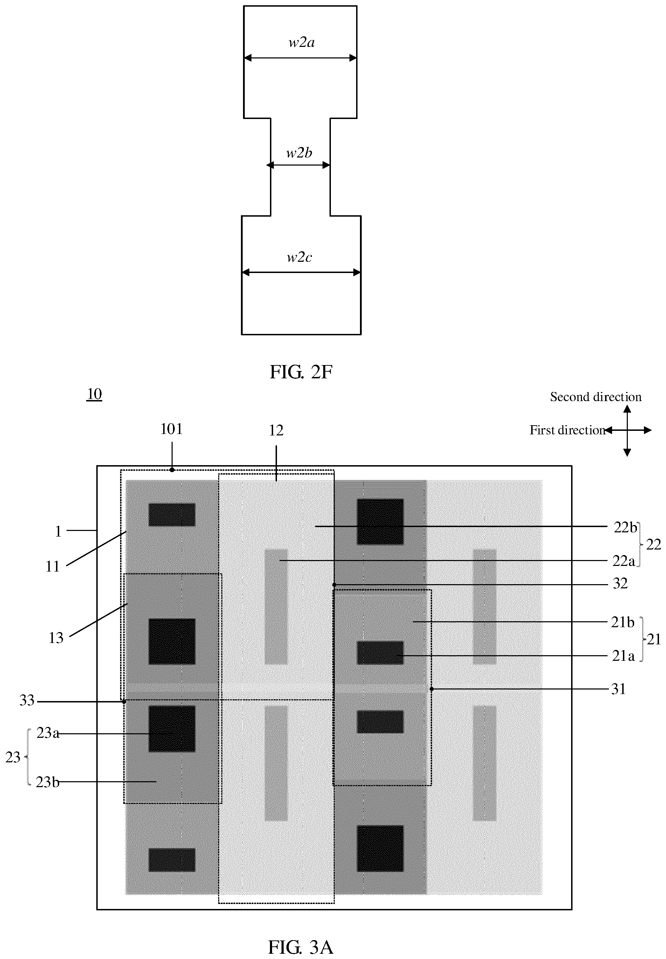

For example, as shown in FIG 1A, in at least one second sub-pixel group 32, the planar shape of the integral structure constituted by the second light-emitting layer 22 of the two consecutively arranged second sub-pixels 12 has a first size *w2a* in a first direction, a second size *w2b* in a first direction, and a third size *w2c* in a first direction, the first size *w2a,* the second size *w2b*, and the third size *w2c* are arranged sequentially in a second direction, and the first size *w2a* is greater than the second size *w2b*, the third size *w2c* is greater than the second size *w2b*, that is, a shape with a smaller middle and two larger ends, and the maximum length of the planar shape of the integral structure constituted by the second light-emitting layer 22 of the two consecutively arranged second sub-pixels 12 in the second direction is greater than the maximum width of this integral structure in the first direction. For example, the first size *w2a* and the third size *w2c* are equal. For another example, the planar shape of the integral structure constituted by the second light-emitting layers 22 of the two consecutively arranged second sub-pixels 12 may be a dumbbell shape as shown in FIG 2F.

For example, as shown in FIG 1A, a planar shape of the first light-emitting layer 21 is a trapezoid, longer bottom edges of the consecutively arranged first light-emitting layers 21 are close to and opposite to each other, for example, the longer bottom edges 31a and 31b of the two consecutively arranged first light-emitting layers 21 are close to each other and opposite to each other, for example, overlap with each other; and/or, the planar shape of the third light-emitting layer 23 is a trapezoid, the longer bottom edges 33a and 33b of the consecutively arranged third light-emitting layer 23 are close to and opposite to each other, for example, overlap with each other. This is beneficial to forming a more regular edge, so that it is convenient for providing the second sub-pixels filling between the two adjacent columns of sub-pixels, and the each of the two adjacent columns of sub-pixels includes the first sub-pixel and the third sub-pixel, and thus a relatively regular gap between the two adjacent columns of sub-pixels is fully utilized, the area of the non-luminous region is reduced, which is beneficial to increase the PPI and the aperture ratio of the display panel. The test data shows that under other same conditions, the display panel that satisfies this feature has a better effect on improving the PPI or the aperture ratio. The effect of improving the PPI and the aperture ratio that can be achieved by the embodiment shown in FIG 1A satisfies the feature shown in FIG 1B, under a same PPI condition, the total pixel aperture ratio can be increased by 70%, and accordingly, the service life of the display panel can be increased by more than 13%; with a same aperture ratio as a common display panel, the PPI of the display panel provided by the embodiments of the present disclosure can be increased by 50%.

For example, a shorter bottom edge 31c of the first light-emitting layer 21 of the first sub-pixel 11 and a shorter bottom edge 33c of the third light-emitting layer 23 of the third sub-pixel 13 adjacent to this first sub-pixel 11 are close to and opposite to each other, for example, the shorter bottom edge 31c of the first light-emitting layer 21 overlaps with the shorter bottom edge 33c of the third light-emitting layer 23. In this way, it is beneficial to forming a more regular edge, so that it is convenient for providing the second sub-pixel filling between the two adjacent columns of sub-pixels, and each of the two adjacent columns of sub-pixels includes the first sub-pixel and the third sub-pixel, and thus a relatively regular gap between the two adjacent columns of sub-pixels is fully utilized, the area of the non-luminous region is reduced, which is beneficial to increase the PPI and the aperture ratio of the display panel. The effect of improving the PPI and the aperture ratio that can be achieved by the embodiment shown in FIG 1A satisfies the feature shown in FIG 1B, under a same PPI condition, the total pixel aperture ratio can be increased by 70%, and a corresponding service life can be increased by more than 13%; with a same aperture ratio as a common display panel, the PPI of the display panel provided by the embodiments of the present disclosure can be increased by 50%.

For example, the display panel 10 further includes a pixel definition layer (not shown in the figure, can be refer to a design of the pixel definition layer in the conventional technology in the art), the pixel definition layer includes a plurality of openings and a body defining the plurality of openings, the plurality of openings of the pixel definition layer are in one-to-one correspondence with the plurality of sub-pixels; in each sub-pixel group of the above-mentioned at least part of the sub-pixel groups (that is, each pixel group includes an integral structure constituted by the light-emitting layers of at least two consecutively arranged sub-pixels), the light-emitting layer of each of the plurality of sub-pixels includes an effective part located within a corresponding opening of the pixel definition layer, and an edge part on the main body of the pixel definition layer. In the patterning process of forming the light-emitting layer, for example, an orthographic projection of the opening of the mask corresponding to each sub-pixel on the base substrate 1 overlaps with an orthographic projection of the entirety constituted by the effective part and the edge part of the sub-pixel on the base substrate 1. The light-emitting layer 21 of the first sub-pixel 11 includes an effective part 21a located in the corresponding opening of the pixel definition layer and the edge part 21b located on the main body of the pixel definition layer; the light-emitting layer 22 of the second sub-pixel 12 includes an effective part 22a located in the corresponding opening of the pixel definition layer and an edge part 22b located on the main body of the pixel definition layer; and the light-emitting layer 23 of the third sub-pixel 13 includes an effective part 23a located within the corresponding opening of the pixel definition layer and an edge part 23b located on the body of the pixel definition layer.

For example, a first distance *h1* between edges of the effective parts 21a of two consecutively arranged first sub-pixels 11 that are close to each other and opposite to each other in each of the at least part of the first sub-pixel groups 31, a second distance *h2* between edges of the effective parts 22a of two consecutively arranged second sub-pixels 12 that are close to each other and opposite to each other in each of the second sub-pixel groups 32, and a third distance *h3* between edges of the effective parts 23a of two consecutively arranged third sub-pixels 13 that are close to each other and opposite to each other in each of the at least part of the third sub-pixel groups 33 are substantially equal, which is beneficial to a balance of display colors of the entire display panel 10.

For example, the first distance *h1,* the second distance *h2* and the third distance *h3* are respectively less than or equal to 8 µm. Compared with the case where two consecutively arranged sub-pixels in the first sub-pixel group 31, in the second sub-pixel group 32 and in the third sub-pixel group 33 do not constitute an integral structure (for example, an interval or a gap exists between two consecutively arranged sub-pixels), the first distance *h1,* the second distance *h2* and the third distance *h3* are relatively small, which can improve the arrangement density of the sub-pixels and is beneficial to improving the PPI of the display panel 10 .

For example, as shown in FIG 1A, a planar shape of the effective part 21a of the first sub-pixel 11, a planar shape of the effective part 22a of the second sub-pixel 12, and a planar shape of the effective part 23a of the third sub-pixel 13 are respectively the same as a planar shape of an entirety of the first light-emitting layer 21, a planar shape of an entirety of the second light-emitting layer 22 , and a planar shape of an entirety of the third light-emitting layer 23, which is beneficial to the uniformity of the arrangement of the light-emitting layer of each sub-pixels of the entire display panel 10, so that the manufacturing difficulty is reduced.

For example, as shown in FIG 1A, in each of the first sub-pixel groups 31, the planar shape of each of the effective parts 21a of the consecutively arranged first sub-pixels 11 is a trapezoid, and longer bottom edges of the effective parts 21a of the two consecutively arranged first light-emitting layers 21 are close to and opposite to each other; and/or, in each of the third sub-pixel groups 33, the planar shape of each of the effective parts 23a of the consecutively arranged third sub-pixels 13 is a trapezoid, and longer bottom edges of the effective parts 23a of the two consecutively arranged third light-emitting layers 23 are close to and opposite to each other. Under the same other conditions, a display panel that satisfies this feature has a better effect of improving the PPI or the aperture ratio. An effect of improving the PPI and the aperture ratio achieved by the embodiment shown in FIG 1A that satisfies this feature is shown in FIG 1B, under a same PPI condition, the total aperture ratio of the pixels can be increased by 70%, and accordingly, the service life of the display panel can be increased by more than 13%; with the same aperture ratio as a common display panel, the PPI of the display panel provided by the embodiments of the present disclosure can be increased by 50%.

For example, as shown in FIG 1A, in each sub-pixel group of the at least part of the sub-pixel groups (that is, each of the pixel groups includes an integral structure composed of light-emitting layers of at least two consecutive sub-pixels), edges of the effective part are in one-to-one correspondence with edges of the outer contour of the edge part, and each pair of mutually corresponding edges (edges right opposite to each other) of the effective part and the outer contour of the edge part are close to and opposite to each other, the distances *S1, S2, S3* between each pair of mutually corresponding edges of the effective part and the outer contour of the edge part are less than or equal to 9 µm, compared with the case where the two consecutive sub-pixels in the first sub-pixel group 31, the second sub-pixel group 32 and the third sub-pixel group 33 do not constitute an integral structure (for example, an interval or a gap exists between the two consecutive sub-pixels), the distances between each pair of mutually corresponding edges of the effective part and the outer contour of the edge part are reduced in the present embodiment.

For example, in the first sub-pixel 11, in the second sub-pixel 12, and in the third sub-pixel 13, the distances from the edges of the effective parts 21a, 22a, 23a to the corresponding edges of the outer contour of the edge part are equal, that is, the distances *S1, S2,* and *S3* are equal; of course, in some other embodiments, the distances *S1, S2,* and *S3* may be unequal. For example, in a display panel with a PPI of 460 or 550, the distances *S1, S2,* and *S3* are all 8.65 µm, in this case, distances *S5, S6,* and *S7* between adjacent and parallel edges of the effective parts of the adjacent sub-pixels with different colors in FIG 1A are all 17.3 µm.

For example, as shown in FIG 1A, the pixel array of the display panel 10 includes a plurality of sub-pixel rows extending in a first direction, a plurality of first sub-pixel columns extending in a second direction, and a plurality of second sub-pixel columns extending in the second direction, each of the second sub-pixel columns is located between two consecutively arranged first sub-pixel columns; the second direction intersects the first direction, for example, in the embodiment shown in FIG 1A, the second direction is perpendicular to the first direction. In each column of the first sub-pixel columns, the first sub-pixel groups 31 and the third sub-pixel groups 33 are alternately arranged; in each column of at least part of the second sub-pixel columns, a plurality of second sub-pixel groups 32 are arranged in sequence, for example, the second sub-pixel 12 is not existed in the first sub-pixel column and the third sub-pixel column; the second light-emitting layer 22 of one of the second sub-pixel groups 32 and the second light-emitting layer of another one second sub-pixel group consecutively arranged with the one of the second sub-pixel groups in the second sub-pixel column do not constitute an integral structure. Due to the technological reasons, in the present embodiment, the light-emitting layers of the two consecutively arranged second sub-pixel groups 32 are respectively formed by two different openings of the mask, so that a gap exists between the light-emitting layers of the two consecutively arranged second sub-pixel groups 32.

For example, in the first direction, the light-emitting layer of the second sub-pixel group 32 are in contact with the light-emitting layers of the adjacent first sub-pixel group 31 and the third sub-pixel group 33 respectively; in the second direction, the light-emitting layer of the first sub-pixel group 31 is in contact with the light-emitting layer of the adjacent third sub-pixel group 33, so that the arrangement of each of the sub-pixels is compact, which is beneficial to improving the PPI and the aperture ratio of the display panel 10.

For example, as shown in FIG 1A, a gap S is between the second light-emitting layer 22 of the one of the second sub-pixel groups 32 and the second light-emitting layer 22 of the another second sub-pixel group 32 consecutively arranged with the one of the second sub-pixel groups 32; the distance h2 between two adjacent effective parts A1 and A3 in the second light-emitting layers 22 with the integral structure of the second sub-pixel group 32 is smaller than a distance h4 between the effective parts A2 and A3 of two adjacent second light-emitting layers 22 that are spaced apart by the gap between each other. In this way, the second light-emitting layers 22 of at least two consecutively arranged second sub-pixels 12 in each of at least part of the second sub-pixel group 32 constitute an integral structure, which can reduce the area of the non-luminous region in the second direction, so that it is beneficial to improving the aperture ratio and the PPI of the display panel 10.

For example, a ratio of the area of the effective part 21a of each of the first sub-pixels 11 to the area of the entire light-emitting layer 21 of each of the first sub-pixels 11 is 17%; a ratio of the area of the effective part 22a of each of the second sub-pixels 12 to the area of the entire light-emitting layer 22 of each of the second sub-pixels 12 is 21%; and a ratio of the area of the effective part 23a of each of the third sub-pixels 13 to the area of the entire light-emitting layer 23 of each of the third sub-pixels 13 is 30%. For example, in the present embodiment, the third sub-pixels 13 are blue sub-pixels, because of low luminous brightness of the blue sub-pixels, a lifetime of current electroluminescent materials that emit blue light is short, so that the ratio of the area of the effective part 23a of the third sub-pixel 13 to the area of the entire light-emitting layer 23 of each of the third sub-pixels 13 is greater than those of the areas of the first sub-pixel (red) and the second sub-pixel (green).

For example, in the embodiment shown in FIG 1A, as shown in a dashed box in the upper left corner of FIG 1A, one first sub-pixel 11 and one third sub-pixel 13 that are adjacent to each other in one first sub-pixel column, and one second sub-pixel 12 in a second sub-pixel column adjacent to the one first sub-pixel column constitute one pixel 101. Compared with other pixel layout methods, such pixel arrangement makes the pixel arrangement more compact, which is more beneficial to improving the aperture ratio and the PPI of the display panel 10; and the length in the first direction and the length in the second direction of the entire planar shape of one pixel are nearly equal, for example, the entire planar shape is nearly a square, which is beneficial to improving the uniformity of the color display of the entire display panel 10, so that the display effect is improved. For example, a region where one pixel 101 is located is a square, a very uniform color display effect is obtained while improving the aperture ratio and PPI of the display panel 10. For example, the length of the second sub-pixel 12 in the second direction is greater than the length of the first sub-pixel 11 in the second direction, and is greater than the length of the third sub-pixel 13 in the second direction, in this way, the length of one second sub-pixel 12 may be substantially equal to the sum of the lengths of one first sub-pixel 11 and one third sub-pixel 13 that are continuously arranged in the second direction, so that the shape of one pixel 101 is regular, and the pixel arrangement is more compact, and thus it is beneficial to improving the aperture ratio and the PPI of the display panel 10 and the uniformity of color display. Corresponding to the arrangement of the pixels, a design of a driving circuit of each of the sub-pixels may refer to conventional techniques in the art. For example, each of the sub-pixels in a pixel is independently driven by its own driving circuit.

Taking FIG 1A as an example, the first sub-pixel 11, the second sub-pixel 12 and the third sub-pixel 13 constitute one pixel 101, the pixel circuits corresponding to the three sub-pixels are respectively arranged in sequence along the first direction, exemplarily, the first sub-pixel 11 is a red sub-pixel, the second sub-pixel 12 is a green sub-pixel, and the third sub-pixel 13 is a blue sub-pixel, the pixel circuits of the three sub-pixels are arranged in the order of red, blue and green, or are arranged in order of blue, red, green, and the pixel circuits of the three sub-pixels are respectively connected with different data lines.

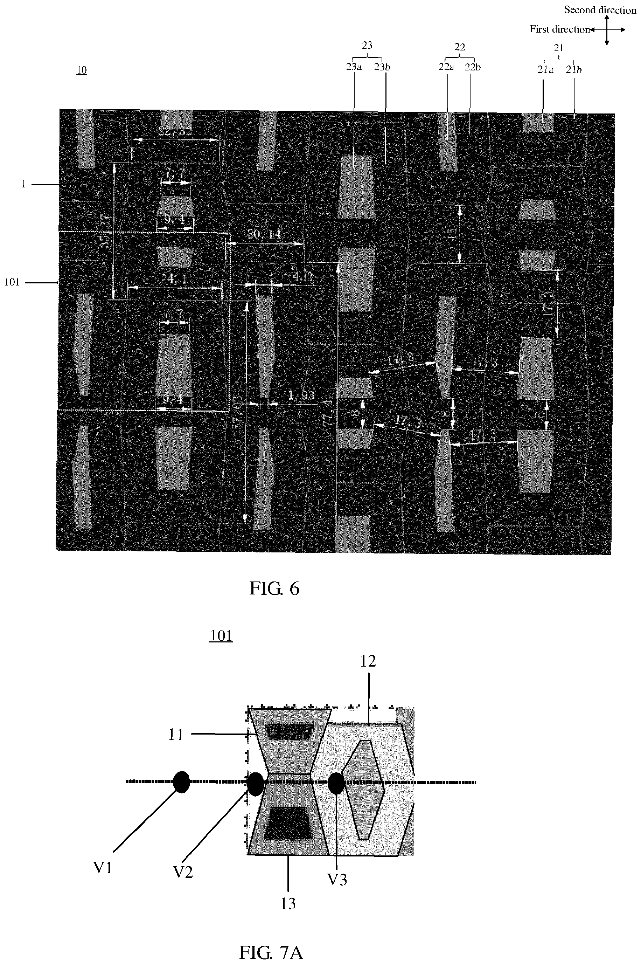

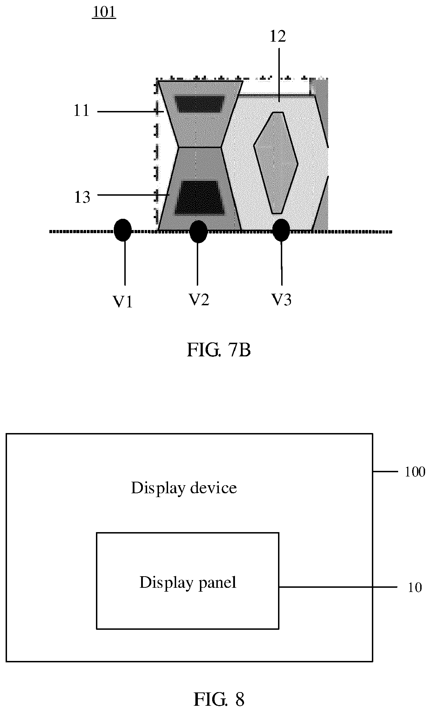

The pixel circuits include, for example, an active layer, a gate insulating layer, a gate electrode layer, an interlayer insulating layer, a source-drain metal layer, and a planarization layer, anode electrodes of the sub-pixels are connected with the pixel circuits through via holes. As shown in FIG 7A and FIG 7B, for the three sub-pixels in one pixel 101, their anode via holes V1, V2, V3 are roughly distributed on a straight line along the first direction, for the first sub-pixel 11 and the third sub-pixel 13 located in a same column, for example, in some embodiments, as shown in FIG 7A, the effective parts of the first sub-pixel 11 and the third sub-pixel 13 are located on a same side of the straight line where the anode via holes V1, V2, and V3 are located; or, in other embodiments, the effective parts of the first sub-pixel 11 and the third sub-pixel 13 are respectively located on different sides of the straight line where the anode via holes V1, V2, V3 are located.

Or, in some other examples, a part circled in the dotted line in the upper left corner of FIG 1A, one first sub-pixel 11, one second sub-pixel 12 and one third sub-pixel 13 that are respectively located in the first sub-pixel group 31, the second sub-pixel group 32 and the third sub-pixel 33 which are continuously arranged in the first direction constitutes one pixel 102. Of course, the arrangement of pixels in the display panel provided by the embodiments of the present disclosure is not limited to the above-mentioned manner, which is not limited in the present disclosure.

For example, as shown in FIG 1A, in each of the first sub-pixel groups 31, the effective parts 21a of the first light-emitting layers 21 of the two consecutively arranged first sub-pixels 11 are symmetrical with respect to the first symmetry axis C1 (as shown by the dotted line) extending along the first direction; and/or, in each of the second sub-pixel groups 32, the effective parts 22a of the second light-emitting layers 22 of the two consecutively arranged second sub-pixels 12 are symmetrical with respect to the second symmetry axis C2 (as shown by the dotted line) extending along the first direction; and/or, in each of the third sub-pixel groups 33, the effective parts 23a of the third light-emitting layers 23 of the two consecutively arranged third sub-pixels 13 are symmetrical with respect to the third symmetry axis C3 (shown by the dotted line) extending along the first direction.

For example, as shown in FIG 1A, geometric centers O1, O2 and O3 of the planar shapes of the first sub-pixel group 31, the second sub-pixel group 32 and the third sub-pixel group 33 arranged in the first direction and located in the same row are substantially located on the same straight line extending in the first direction. Of course, it is not limited that the geometric centers of the consecutively arranged first sub-pixels 11, second sub-pixels 12 and third sub-pixels 13 are substantially located on the same straight line extending along the first direction, for example, the geometric centers of all of the first sub-pixels 11, the second sub-pixels 12 and the third sub-pixels 13 located in the same row are substantially located on the same straight line extending along the first direction. In this case, for example, for the first sub-pixel group 31, the second sub-pixel group 32 and the third sub-pixel group 33 that are arranged in the first direction and are located in the same row, the first symmetry axis C1, the second symmetry axis C2 and the third symmetry axis C3 coincide.

For example, the effective part 22a of the second light-emitting layer 22 has an symmetry axis in a same direction as that of the effective parts of the first light-emitting layer 21 and the third light-emitting layer 23, or the effective part 22a of the second light-emitting layer 22 does not have an symmetry axis in a same direction as that of the effective part of the light-emitting layer.

For example, in each of the first sub-pixel groups 31, the effective part 21a of each of the first sub-pixels 11 includes a near edge E1 close to the first symmetry axis C1 and a far edge E2 away from the first symmetry axis C1, a length of the near edge E1 of the effective part 21a of each of the first sub-pixels 11 is greater than a length of the far edge E2 of each of the first sub-pixels 11; and/or, in each of the second sub-pixel groups 32, the effective part 22a of each of the second sub-pixels 12 includes a near edge F1 close to the second symmetry axis C2 and a far edge F2 away from the second symmetry axis C2, a length of the near edge F1 of the effective part 22a of each of the second sub-pixels 12 is greater than a length of the far edge F2 of the effective part 22a of each of the second sub-pixels 12; and/or, in each of the third sub-pixel groups 31, the effective part 23a of each of the third sub-pixels 13 includes a near edge G1 close to the third symmetry axis C3 and a far edge G2 away from the third symmetry axis C3, a length of the near edge G1 of the effective part 23a of each of the third sub-pixels 13 is greater than a length of the far edge G2 of the effective part 23a of each of the third sub-pixels 13. Therefore, it is beneficial to make the planar shape of the effective part 21a of the first sub-pixel 11, the planar shape of the effective part 22a of the second sub-pixel 12, and the planar shape of the effective part 23a of the third sub-pixel 13 consistent with the overall planar shape of the first light-emitting layer 21, the overall planar shape of the second light-emitting layer 22, and the overall planar shape of the third light-emitting layer 23, respectively, and it is beneficial to the uniformity of the arrangement of the light-emitting layer of each of the sub-pixels of the entire display panel 10, so that the difficulty of production is reduced.

For example, at least two selected from a group consisting of a distance from the near edge E1 of the effective part 21a of each of the first sub-pixels 11 of each of the first sub-pixel groups 31 to the second symmetry axis, a distance from the near edge F1 of the effective part 22a of each of the second sub-pixels 12 of each of the second sub-pixel groups 32 to the second symmetry axis C2, and a distance from the near edge G1 of the effective part 23a of each of the third sub-pixels 13 of each of the third sub-pixel groups 33 to the third symmetry axis C3 are substantially equal, for example, the three are basically equal. Because the shapes of the first sub-pixel group 31, the second sub-pixel group 32 and the third sub-pixel group 33 are symmetrical, the distance *h1* between the near edges E1 of the effective parts 21a of the two first sub-pixels 11 arranged consecutively in each of the first sub-pixel groups 31, a distance *h2* between the near edges F1 of the effective parts 22a of the two second sub-pixels 12 arranged consecutively in each of the second sub-pixel groups 32, and a distance *h3* between the near edges G1 of the effective parts 23a of the two third sub-pixels 13 arranged consecutively in each of the third sub-pixel groups 33 are basically equal, which is beneficial to the balance of display colors of the entire display panel 10.

For example, the first direction is a width direction of each of the sub-pixels, and the second direction is a length direction of each of the sub-pixels; in one pixel 101, the aspect ratio of the effective part of the second sub-pixel 12 is greater than the aspect ratio of the effective part of the third sub-pixel 13, and is larger than the aspect ratio of the effective part of the first sub-pixel 11. The aspect ratio of the effective part 21a of the first sub-pixel 11 ranges from 1:2.5 to 1:1, the aspect ratio of the effective part 22a of the second sub-pixel 12 ranges from 9:1 to 2:1, the aspect ratio of the effective part 23a of the third sub-pixel 13 ranges from 3:1 to 1:1, in this case, a better compact arrangement can be achieved, a balanced proportion of the effective part of each of the sub-pixels is realized, and a better effect of improving the PPI and the aperture ratio of the display panel 10 is achieved. Of course, the three aspect ratios are not limited to the ranges listed above.

For example, a width *w2a* of the second light-emitting layer 22 of one second sub-pixel 12 in the width direction is greater than or equal to a width *w1* of the second light-emitting layer 21 of one first sub-pixel 11 in the width direction, and is greater than or equal to a width w3 of the third light-emitting layer 23 of one third sub-pixel 13 in the width direction. Such a design is beneficial to the balance of display colors, and a better color display effect can be obtained. For example, the width *w1* of the first light-emitting layer 21 of one first sub-pixel 11, the width *w2a* of the second light-emitting layer 22 of one second sub-pixel 12, and the width *w3* of the third light-emitting layer 23 of one third sub-pixel 13 respectively refer to maximum widths of light-emitting layers of the first sub-pixel 11, the second sub-pixel 12 and the third sub-pixel 13 in the width direction.

For example, as shown in FIG 1A, a ratio of a width *w2b* of one of the second sub-pixels 12 in the width direction to the width *w1* of one of the first sub-pixels 11 ranges from 1:1 to 1:2; and a ratio of the width *w2b* of one of the second sub-pixels 12 to the width *w1* of one of the third sub-pixels 13 ranges from 1:1 to 1:2. If this ratio is too large, the display color will be unbalanced, and a better color display effect can be obtained under this ratio range. Similarly, for example, the planar shape of the effective part 21a of the first sub-pixel 11, the planar shape of the effective part 22a of the second sub-pixel 12, and the planar shape of the effective part 23a of the third sub-pixel 13, are respectively the same as the planar shape of the second light-emitting layer 21 of the first sub-pixel 11, the planar shape of the second light-emitting layer 22 of the second sub-pixel 12, and the planar shape of the third light-emitting layer 23 of the third sub-pixel 13, in this case, the ratio of the width *w2b* of the effective part 22a of one of the second sub-pixels 12 in the width direction to the width *w1* of the effective part 21a of one of the first sub-pixels 11 ranges from 1:1 to 1:2; and the ratio of the width *w2b* of the effective part 22a of one of the second sub-pixels 12 to the width w3 of the effective part 23a of one of the third sub-pixels 13 ranges from 1:1 to 1:2.

For example, a length *l2* in the length direction of one of the second sub-pixel groups 32 including the second light-emitting layer with an integral structure is greater than a length *l1* in the length direction of one of the first sub-pixel groups 31 including the first light-emitting layer with an integral structure, and is greater than a length *l3* in the length direction of one of the first sub-pixel groups 31 including the third light-emitting layer with an integral structure. For example, in at least one display panel 10 with a PPI of 460 or 550, the length *l1* is 39.7 µm, the length *l2* is 95.4 µm, and the length *l3* is 70.7 µm.

As shown in FIG 1A, the plurality of pixels 101 including the first sub-pixel 11, the second sub-pixel 12 and the third sub-pixel 13 are respectively arranged periodically in the first direction and the second direction; in one pixel 101, the first sub-pixel 11, the second sub-pixel 12 and the third sub-pixel 13 are not aligned in the second direction, and edges of the second sub-pixel 12 close to the first sub-pixel 11 and the third sub-pixel 13 overlap with the edge of the first sub-pixel 11 and the edge of the third sub-pixel 13 that are close to the second sub-pixel 12 respectively, that is, the second sub-pixel 12 is in contact with both the first sub-pixel 11 and the third sub-pixel 13, that is, the second sub-pixel 12 overlaps with both the first sub-pixel 11 and the third sub-pixel 13 in the first direction, to make full use of a gap between two columns of sub-pixels, the gap is filled with sub-pixels, the area of the non-luminous region is reduced, which is beneficial to improving the PPI and the aperture ratio of the display panel, so that a good color accuracy is maintained.

For example, a plurality of the second sub-pixels 12 located in the same row overlap in the second direction, and the plurality of second sub-pixels located in the same column overlap in the first direction.

For example, a planar shape of the effective part 22a of the second light-emitting layer 22 is a polygon, and the polygon may include a rounded corner or a curved edge, which is not limited herein.

For example, an included angle is between a direction of a longest dimension of the effective light-emitting part of at least one selected from the group consisting of the first sub-pixel 11, the second sub-pixel 12, and the third sub-pixel 13, and the first direction or the second direction, and the included angle is greater than 0 degree and less than or equal to 45 degrees. Of course, in some embodiments, the included angle may be equal to 0 degree. As shown in FIG 1A, the direction D1 of the longest dimension of the effective part is the same as the first direction, that is, the included angle between the direction D1 and the first direction is 0 degree; an angle θ2 between the direction D2 of the longest dimension of the effective part 22a of the second sub-pixel 12 the second direction is less than 45 degrees; an angle θ3 between a direction D3 of the longest dimension of the effective light-emitting part 23a of the third sub-pixel 13 and the second direction is less than 45 degrees.

For example, the planar shape of the effective part 22a of the second light-emitting layer 22 includes a first parallel edge H1 and a second parallel edge H2, the first parallel edge H1 is parallel to at least one edge of the effective part 21a of the first light-emitting layer 21 adjacent to the second light-emitting layer 22, such as the edge 11, the second parallel edge H2 is parallel to at least one edge of the effective part 23a of the third light-emitting layer 23 adjacent to the second light-emitting layer 22 , for example, the edge J2.

For example, a length of the effective part 22a of the second sub-pixel 12 in the second direction is greater than a length of the effective part 21a of the first sub-pixel 11 in the second direction, and is larger than a length of the effective part 23a of the third sub-pixel 13 in the second direction. For example, a length of the second sub-pixel 12 in the second direction is greater than a length of the first sub-pixel 11 in the second direction, and is greater than a length of the third sub-pixel 13 in the second direction.

For example, in the case that shapes of each of the first sub-pixels 11 and each of the third sub-pixels 13 are symmetrical, a distance *S5* in the above-mentioned FIG 1A is equal to a distance between the first parallel edge H1 and the edge 11, a distance *S6* is equal to a distance between the second parallel edge H2.

Further, the planar shape of the effective part 22a of the second light-emitting layer further includes a third parallel edge, and the third parallel edge is parallel to at least one edge of the effective part of the first light-emitting layer, the second light-emitting layer or the third light-emitting layer directly adjacent to the second light-emitting layer.

Further, the planar shape of the effective part 22a of the second light-emitting layer further includes a fourth parallel edge, and the third parallel edge is parallel to at least one edge selected from a group consisting of the effective part of the first light-emitting layer, the second light-emitting layer or the third light-emitting layer directly adjacent to the second light-emitting layer, at this time, the planar shape of the effective part 22a of the second light-emitting layer is a quadrangle.

Further, the planar shape of the effective part 22a of the second light-emitting layer further includes a fifth parallel edge, and the third parallel edge is parallel to at least one edge selected from a group consisting of the effective part of the first light-emitting layer, the second light-emitting layer or the third light-emitting layer directly adjacent to the second light-emitting layer, at this time, the planar shape of the effective part 22a of the second light-emitting layer is a pentagon.

Further, the planar shape of the effective part 22a of the second light-emitting layer further includes a sixth parallel edge, and the third parallel edge is parallel to at least one edge selected from a group consisting of the effective part of the first light-emitting layer, the second light-emitting layer or the third light-emitting layer directly adjacent to the second light-emitting layer, at this time, the planar shape of the effective part 22a of the second light-emitting layer is a hexagon, and so on.

The first light-emitting layer, the description "the second light-emitting layer or the third light-emitting layer directly adjacent to the second light-emitting layer" refers to connecting the light-emitting layer and the effective part 22a of the second light-emitting layer to form a plurality of connection lines, and at least one of the connection lines does not pass through other light-emitting layers.

For example, in the embodiment shown in FIG 1A, the planar shape of the second light-emitting layer 21 is symmetrical with respect to the symmetry axis extending along the second direction, to make the arrangement of the light-emitting layers of the sub-pixels of the display panel 10 symmetrical, so that the uniformity of the display effect of the display panel 10 is improved. Or, in some other embodiments, the planar shape of the second light-emitting layer 22 does not have a symmetry axis extending in the second direction. The present disclosure does not limit this.

For example, as shown in FIG 1A, the second light-emitting layer 22 is located between the first light-emitting layer 21 and the third light-emitting layer 23 that are in the two first sub-pixel columns adjacent to the second light-emitting layer 22, the planar shape of the second light-emitting layer 22 fills the gap between the first light-emitting layer 21 and the second light-emitting layer 23 in the adjacent two first sub-pixel columns. That is, the shapes of the first light-emitting layer 21, the second light-emitting layer 22 and the first light-emitting layer 21 that are consecutively arranged are complementary to each other, so that the area of the non-luminous region is reduced, which is beneficial to improving the aperture ratio and the PPI of the display panel.

For example, as shown in FIG 1A, in each of the second sub-pixel groups, a planar shape of the integral structure constituted by the second light-emitting layers 22 of the two consecutively arranged second sub-pixels 12 is basically a dumbbell shape, the maximum length of the dumbbell shape in the second direction is greater than the maximum width of the dumbbell shape in the first direction.

For example, the area of the light-emitting layer of the second sub-pixel 12 is larger than the area of the light-emitting layer of the first sub-pixel 11, and is larger than the area of the light-emitting layer of the third sub-pixel 13.

For example, as shown in FIG 1A, the first light-emitting layer 21 of the first sub-pixel 11, the second light-emitting layer 22 of the second sub-pixel 12, and the third light-emitting layer 23 of the third sub-pixel 13 have parts that face each other in the second direction, that is, drawing a straight line along the second direction, and the straight line passes through the first light-emitting layer 21 of the first sub-pixel 11, the second light-emitting layer 22 of the second sub-pixel 12, and the third light-emitting layer 23 of the third sub-pixel 13, so that a compactness of the arrangement of the sub-pixels in the entire display panel 10 is improved, which is beneficial to improving the aperture ratio and the PPI of the display panel.

For example, the first sub-pixels in any two consecutively arranged pixels in the plurality of pixels are different first sub-pixels, the second sub-pixels in any two consecutively arranged pixels in the plurality of pixels are different second sub-pixels, and the third sub-pixels in any two consecutively arranged pixels in the plurality of pixels are different third sub-pixels. In this way, when the display panel performing display operation, each of the pixels includes a red pixel, a green pixel, and a blue pixel, the sub-pixels of adjacent units do not need to be borrowed, so that in the case that a certain graphic is displayed, display defects such as white borders of the graphic are avoided.

For example, in at least one embodiment, for example, in a display panel with a PPI of 460, a dimension S4 of an interval S in the second direction is 15 µm; a length *d1* of a shorter edge of the effective part 21a of the first sub-pixel 11 is 7.7 µm, a length d*2* of a longer edge of the effective part 21a of the first sub-pixel 11 is 9.4 µm; a length *d3* of a shorter edge of the effective part 23a of the third sub-pixel 13 is 7.7 µm, and a length *d3* of a longer edge of the effective part 23a of the third sub-pixel 12 is 9.4 µm.

FIG 2A is a schematic structural diagram of another display panel provided by an embodiment of the present disclosure. The difference between the display panel shown in FIG 2A and the display panel shown in FIG 1 is that, as shown in FIG 2A, in each of the first sub-pixel groups 31, the first light-emitting layers 21 of the consecutively arranged first sub-pixels 11 constitute an integral structure; in each of the third sub-pixel groups 33, the third light-emitting layers 23 of the consecutively arranged third sub-pixels 13 constitute an integral structure; in each of the second sub-pixel groups 32, the second light-emitting layers 22 of the consecutively arranged second sub-pixels 12 do not constitute an integral structure, in each of the second sub-pixel groups 32, an interval S (non-luminous region) is between the second light-emitting layers 22 of the consecutively arranged second sub-pixels 12, so that in each of the pixels, the arrangement of the second sub-pixel 12 (for example, a green sub-pixel), the first sub-pixel 11 (for example, a red sub-pixel) and the third sub-pixel 13 (for example, a blue sub-pixel) is more compact, and the distance relationship is more stable, the color accuracy is improved while the PPI and aperture ratio of the display panel are improved. The embodiment shown in FIG 2A can also reduce the area of the non-luminous region to a certain extent, which is beneficial to the technical effect of improving the PPI and the aperture ratio of the display panel.

Other features not mentioned in the display panel shown in FIG 2A are the same as the features shown in FIG 1A, please refer to the previous descriptions, which is omitted herein.

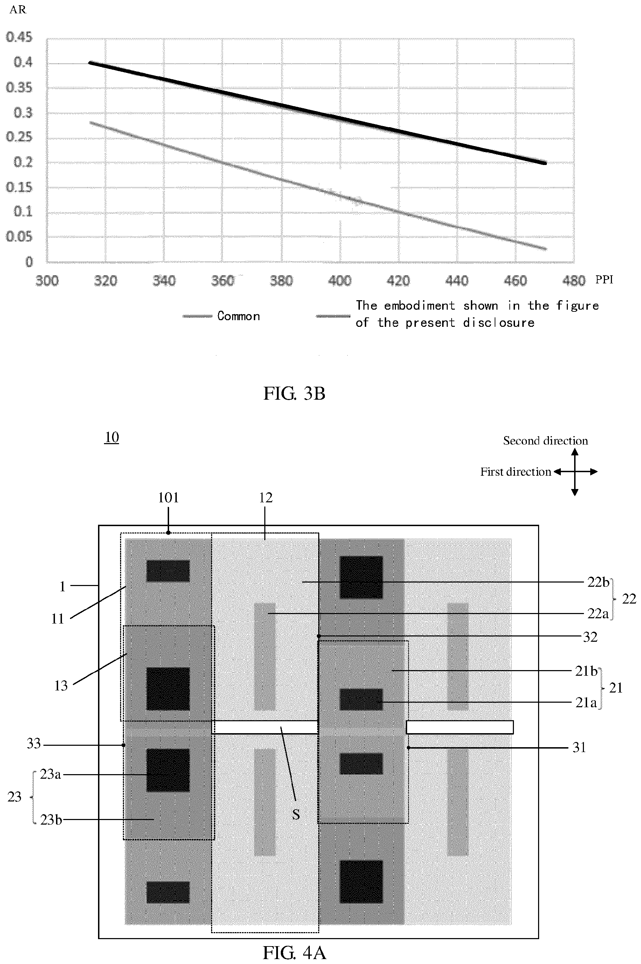

FIG 3A is a schematic structural diagram of still another display panel provided by an embodiment of the present disclosure, FIG 3B is a comparison diagram of the aperture ratio and pixel density of the display panel shown in FIG 3A and the aperture ratio and the pixel density of the common display panel, and difference between the display panel shown in FIGS. 3A to 3B and FIG 1A is that, as shown in FIG 3A, the planar shape of the first light-emitting layer 21, the planar shape of the second light-emitting layer 22 and the planar shape of the third light-emitting layer 23 are all rectangular; the planar shape of the effective part 21a of the first light emitting layer 21, the planar shape of the effective part 22a of the second light emitting layer 22, and the planar shape of the effective part 23a of the third light emitting layer 23 are all rectangular. The embodiment shown in FIG 3A can also reduce the area of the non-luminous region to a certain extent, which is beneficial to the technical effect of improving the PPI and the aperture ratio of the display panel. As shown in FIG 3B, under a condition of a same PPI, a total pixel aperture ratio AR can be increased by 52%, and correspondingly, a service life of the display panel is increased by more than 11%. With a same aperture ratio, the PPI of the display panel can be increased by 24%. Other features not mentioned of the display panel shown in FIG 3A are the same as the features shown in FIG 1A, please refer to the previous descriptions, which are omitted herein.

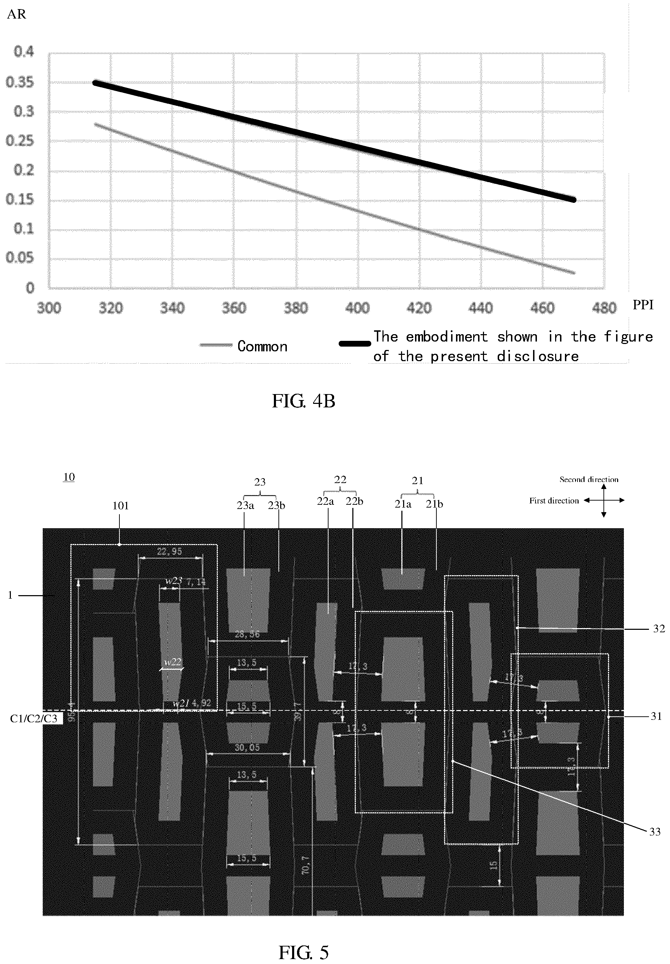

FIG 4A is a schematic structural diagram of still another display panel provided by an embodiment of the present disclosure, and FIG 4B is a comparison diagram of the aperture ratio and pixel density of the display panel shown in FIG 4A and the aperture ratio and the pixel density of the common display panel. Difference between the display panel shown in FIGS. 4A to 4B and FIG 1A is that, the planar shape of the first light-emitting layer 21, the planar shape of the second light-emitting layer 22 and the planar shape of the third light-emitting layer 23 are all rectangular; the planar shape of the effective part 21a of the first light emitting layer 21, the planar shape of the effective part 22a of the second light emitting layer 22 and the planar shape of the effective part 23a of the third light emitting layer 23 are all rectangular; and in each of the second sub-pixel groups 32, the second light-emitting layers 22 of the consecutively arranged second sub-pixels 12 do not constitute an integral structure; in each of the second sub-pixel groups 32, a gap S (non-luminous region) is between the second light-emitting layers 22 of the consecutively arranged second sub-pixels 12, so that in each of the pixels, the arrangement of the second sub-pixel 12 (for example, a green sub-pixel), the first sub-pixel 11 (for example, a red sub-pixel) and the third sub-pixel 13 (for example, a blue sub-pixel) are more compact, and the distance relationship is more stable, and the color accuracy is improved while the PPI and the aperture ratio of the display panel are increased. The embodiment shown in FIG 4A can also reduce the area of non-luminous region to a certain extent, which is beneficial to the technical effect of improving the PPI and the aperture ratio of the display panel, and as shown in FIG 4B, under the same PPI condition, the total opening of the pixels can be increased by 75%, and correspondingly, the service life can be increased by more than 32%. With a same aperture ratio, the PPI can be increased by 8%. Other features not mentioned of the display panel shown in FIG 3A are the same as those shown in FIG 1A, please refer to the previous descriptions, which are omitted herein.

Of course, in other embodiments, it may be that in each of the first sub-pixel groups 31, the first light-emitting layers 21 of the consecutively arranged first sub-pixels 11 constitute an integral structure, in each of the first sub-pixel groups 31, a gap (non-luminous region) is between the first light-emitting layers 21 of the consecutively arranged first sub-pixels 11. Alternatively, in each of the third sub-pixel groups 32, the third light-emitting layers 23 of the consecutively arranged third sub-pixels 13 do not constitute an integral structure, and in each of the third sub-pixel groups 33, a gap (non-luminous region) is between the third light-emitting layers 23 of the consecutively arranged third sub-pixels 13.

As shown in FIG 5, for example, the planar shape of the effective part 22a of the second sub-pixel 12 is an irregular pattern. For example, at least a part of the effective part 22a of the second sub-pixel 12 has a first width *w21*, a second width *w22* and a third width *w23* that are sequentially away from the second symmetry axis C2 in the first direction, the second width *w22* is greater than the first width *w21*, and the third width *w23* is greater than the first width *w21*. For example, the third width *w23* is 7.14µm, and the first width *w21* is 4.92µm; for example, a range of the second width is greater than 4.92 µm and less than 7.14µm. The embodiment shown in FIG 5 can further reduce the area of the non-luminous region to a certain extent, which is beneficial to the technical effect of improving the PPI and the aperture ratio of the display panel.

For example, in the embodiment shown in FIG 5, the PPI of the display panel is 460, the first width *w21* is 7.14 µm, the third width *w23* is 4.92 µm, the second width *w22* is greater than 4.92 µm and less than or equal to 7.14 µm; a size *S4* of the gap S in the second direction is 15 µm; the length *d1* of the shorter edge of the effective part 21a of the first sub-pixel 11 is 13.5 µm, the length *d2* of the longer edge of the effective part 21a of the first sub-pixel 11 is 13.5 µm; the length *d3* of the shorter edge of the effective part 23a of the third sub-pixel 13 is 13.5 µm, and the length *d3* of the longer edge of the effective part 23a of the third sub-pixel 12 is 13.5 µm. Some other dimensions may refer to FIG 5 for details.

Other features not mentioned of the display panel shown in FIG 5 are the same as the features shown in FIG 1A, please refer to the previous descriptions, which are omitted herein.

FIG 6 is a schematic structural diagram of a display panel with a pixel density different from that in FIG 5 provided by an embodiment of the present disclosure. With respect to FIG 5, in FIG 6, distances between the effective parts of the light-emitting layers of the respective sub-pixels does not change, but sizes of the effective part of the light-emitting layer of each of the sub-pixels are reduced.

For example, in the embodiment shown in FIG 6, the PPI of the display panel is 550, and the size *S4* of the gap S in the second direction is 15 µm; the length *d1* of the shorter edge of the effective part 21a of the first sub-pixel 11 is 7.7 µm, the length *d2* of the longer edge of the effective part 21a of the first sub-pixel 11 is 9.4 µm; the length *d3* of the shorter edge of the effective part 23a of the third sub-pixel 13 is 7.7 µm, and the length d3 of the longer edge of the effective part 23a of the third subpixel 12 is 9.4 µm.

Other features not mentioned of the display panel shown in FIG 6 are the same as the features in FIG 5, please refer to the previous descriptions, which are omitted herein.

For example, the display panel provided by at least one embodiment of the present disclosure further includes a driving structure layer, the driving structure layer includes a plurality of driving circuits, and each of the sub-pixels includes a driving circuit.

At least one embodiment of the present disclosure further provides a display device, FIG 8 is a schematic diagram of a display device provided by an embodiment of the present disclosure; as shown in FIG 8, the display device 100 includes any one of the display panels 10 provided by the embodiments of the present disclosure. For example, the display device can be any product or component with display function and touch function, such as a display, an OLED panel, an OLED TV, an electronic paper, a mobile phone, a tablet computer, a notebook computer, a digital photo frame, and a navigator. Other structures of the display device may refer to conventional techniques in the art.

At least one embodiment of the present disclosure further provides a manufacturing method of a display panel, and the manufacturing method includes: providing a base substrate; and forming a plurality of sub-pixels on the base substrate, in which each of the at least part of the sub-pixels includes a light-emitting layer, in which a mask is used to form the light-emitting layers of the plurality of sub-pixels through a patterning process, the mask includes a plurality of mask openings; at least two sub-pixels arranged consecutively in the plurality of sub-pixels constitute one sub-pixel group, in the patterning process, the light-emitting layers of each sub-pixel group in at least part of the sub-pixel groups is formed by one same mask opening among the plurality of mask openings and made of a same material. For example, the at least part of the sub-pixel groups includes at least two sub-pixel groups that respectively emit light of different colors. Usually, because of process reasons, in the process of forming the light-emitting layer of a same color through the patterning process, gaps are provided between the light-emitting layers of adjacent sub-pixels formed by different openings of the mask, however, no such gap is provided between the light-emitting layers of the at least two consecutively arranged sub-pixels formed by one same opening of the mask, so that the area of the non-luminous region can be reduced, which is beneficial to increase the PPI and the aperture ratio of the display panel.

For example, in each sub-pixel group of the at least part of the sub-pixel groups, the light-emitting layers of the consecutively arranged sub-pixels formed by the openings in the same mask constitute an integral structure.

For example, the plurality of sub-pixels included in each of the plurality of pixels includes: a first sub-pixel 11, a second sub-pixel 12, and a third sub-pixel 13. The first sub-pixel 11 includes a first light-emitting layer 21, the first light-emitting layer 21 emits first color light; the second sub-pixel 12 includes a second light-emitting layer 22, the second light-emitting layer 22 emits second color light; the third sub-pixel 13 includes a third light-emitting layer 23, the third light-emitting layer 23 emits third color light, and colors of the first color light, the second color light, and the third color light are different from each other. For example, the first light-emitting layer emits red light, the second light-emitting layer emits green light, and the third light-emitting layer emits blue light. In the patterning process, at least one or at least two of the following steps are performed: forming the first light-emitting layer of each of the first sub-pixel groups by one same mask opening in the plurality of mask openings, forming the second light-emitting layer of each of the second sub-pixel groups by one same mask opening in the plurality of mask openings, and forming a third light emitting layer of each of the third sub-pixel groups by one same mask opening among the plurality of mask openings.

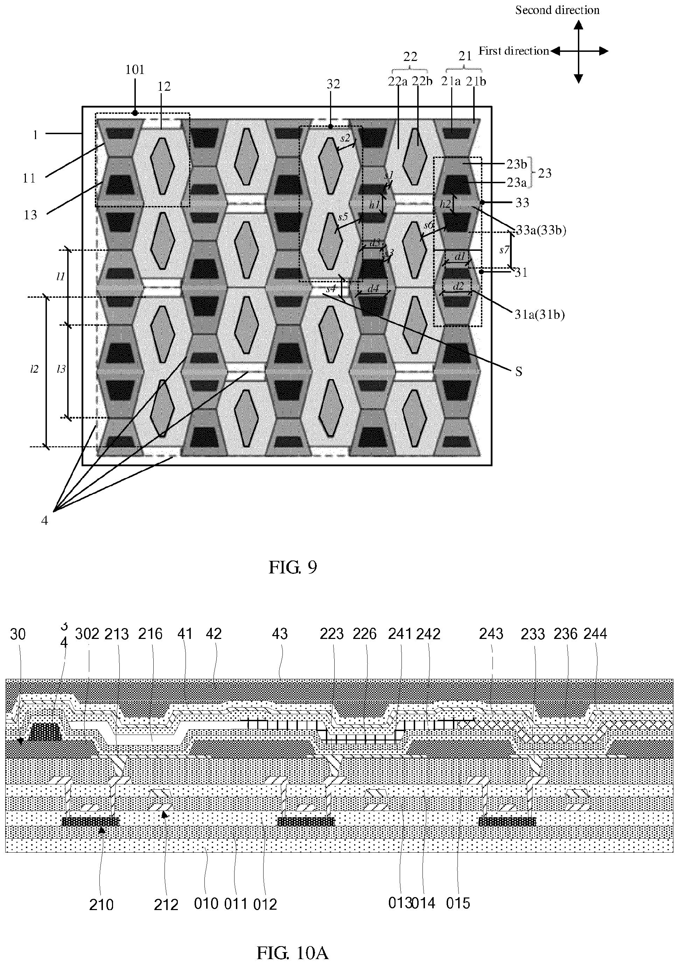

FIG 9 is a schematic diagram of a manufacturing method of a display panel using a mask provided by an embodiment of the present disclosure. As shown in FIG 9, for example, the mask is an evaporation mask, such as a metal mask, which includes a plurality of mask openings defined by metal lines 4. The plurality of mask openings include a first mask opening, a second mask opening, and a third mask opening. In the patterning process, the first light-emitting layer of each of the first sub-pixel groups is formed by one same first mask opening, the second light-emitting layer of each of the second sub-pixel groups is formed by one same second mask opening, and the third light-emitting layer of each of the third sub-pixel groups is formed by one same third mask opening, that is, the light-emitting layers of at least two sub-pixels arranged consecutively in three colors are formed through one same opening, so that the PPI and the aperture ratio of the display panel can be better improved. The orthographic projection of the first mask opening, the orthographic projection of the second mask opening and the orthographic projection of the third mask opening on the base substrate 1 substantially overlaps with the first light emitting layer of each of the first sub-pixel groups, the second light emitting layer of each of the second subpixel groups, and the third light emitting layer of each of the third subpixel groups that are formed, respectively. The display panel formed by this manufacturing method can be as shown in FIG 1A, specific features and technical effects of the display panel may refer to the descriptions of FIG 1A.

For example, in other embodiments, in the patterning process, the first light-emitting layer of each of the first sub-pixel groups is formed by one same first mask opening, the plurality of second mask openings are in one-to-one correspondence with the second light-emitting layers of the plurality of second sub-pixels, the second light-emitting layers of the plurality of second sub-pixels are formed by using a plurality of second mask openings, respectively, the third light-emitting layer of each of the third sub-pixel groups is formed by using one same third mask opening, so that the PPI and the aperture ratio of the display panel are improved while the high color accuracy is maintained. The display panel formed by this manufacturing method may be as shown in FIG 2A or FIG 4A, and specific features and technical effects of the display panel can refer to the descriptions of FIG 2A or FIG 4A.

For example, the manufacturing method of the display panel further includes: before forming the light-emitting layer, forming the pixel definition layer, in which the pixel definition layer includes a plurality of mask openings and a main body defining the plurality of the mask openings, the plurality of the mask openings are in one-to-one correspondence with the plurality of the sub-pixels; in the process of forming the light-emitting layers of the plurality of sub-pixels through the patterning process using a mask, the plurality of mask openings of the pixel definition layer are in one-to-one correspondence with the plurality of the mask openings of the mask, and orthographic projections of the plurality of the mask openings of the pixel definition layer on the base substrate are respectively located within orthographic projections of the plurality of the mask openings of the mask on the base substrate; the light-emitting layer of each of the plurality of sub-pixels includes an effective part located within a mask opening of the corresponding pixel definition layer, and an edge part located on the main body of the pixel definition layer, an orthographic projection of the edge part on the base substrate is outside an orthographic projection of the corresponding mask opening on the base substrate and is within an orthographic projection of the mask opening of the corresponding mask on the base substrate. Specific structural features of the effective part and the edge part that are formed may refer to the descriptions in the previous embodiments of the display panel, which are omitted herein.

For example, the manufacturing method of the display panel provided by at least one embodiment of the present disclosure further includes: forming a driving structure layer, in which the driving structure layer includes a plurality of driving circuits, and each of the sub-pixels includes a driving circuit to be driven independently. The manufacturing method of the display panel provided by at least one embodiment of the present disclosure further includes forming a plurality of other functional layers, details may be referred to the following examples.

FIG 10A is a schematic diagram of an exemplary layer structure of a pixel array; as shown in FIG 10A, the method may specifically include the following steps:
Step 1: manufacturing a base substrate on a glass carrier.

In some exemplary embodiments, the base substrate 10 may be a flexible base substrate, for example, including a first flexible material layer, a first inorganic material layer, a semiconductor layer, a second flexible material layer and a second inorganic material layer that are stacked on the glass carrier. Materials of the first flexible material layer and the second flexible material layer may be polyimide (PI), polyethylene terephthalate (PET), or surface-treated soft polymer films, etc. Materials of the first inorganic material layer and the second inorganic material layer may be silicon nitride (SiNx) or silicon oxide (SiOx), etc., which are used to improve water and oxygen resistance of the base substrate, the first inorganic material layer and the second inorganic material layer are also called barrier layers. Material of the semiconductor layer may be amorphous silicon (a-si). In some exemplary embodiments, taking the stacked structure PI1Barrier1/a-si/PI2/Barrier2 as an example, the manufacturing process includes: firstly coating a layer of polyimide on the glass carrier 1, and then forming a first flexible (PI1) layer after curing into a film; subsequently depositing a barrier film on the first flexible layer, to form a first barrier (Barrier1) layer covering the first flexible layer; then depositing an amorphous silicon film on the first barrier layer, to form an amorphous silicon (a-si) layer covering the first barrier layer; then coating a layer of polyimide on the amorphous silicon layer, and forming a second flexible (PI2) layer after curing into a film; and then depositing a barrier film on the second flexible layer, to form a second barrier (Barrier2) layer covering the second flexible layer, thus the manufacture of the base substrate 10 is completed, as shown in FIG 6.

Step 2: manufacturing the driving structure layer on the base substrate. The driving structure layer includes a plurality of driving circuits, each of the driving circuits includes a plurality of transistors and at least one storage capacitor, such as a 2T1C, 3T1C or 7T1C design. The three sub-pixels are taken as an example for illustration, and the driving circuit of each of the sub-pixels is only illustrated by taking one transistor and one storage capacitor as an example.

In some embodiments, the manufacturing process of the driving structure layer may refer to the following descriptions. The manufacturing process of the driving circuit of the red sub-pixel is taken as an example for description.

A first insulation layer and an active layer film are sequentially deposited on the base substrate 10, the active layer film is patterned by a patterning process, and a first insulation layer 011 covering the entire base substrate 010 and an active layer pattern arranged on the first insulation layer 011 are formed, in which the active layer pattern includes at least a first active layer.

Then a second insulation layer and a first metal film are sequentially deposited, and the first metal film is patterned by a patterning process, and a second insulation layer 012 covering the active layer pattern and a first gate metal layer pattern arranged on the second insulation layer 012 are formed, in which the first gate metal layer pattern at least includes a first gate electrode and a first capacitor electrode.

Then a third insulation layer and a second metal film are sequentially deposited, the second metal film is patterned by a patterning process, and a third insulation layer 013 covering the first gate metal layer and a second gate metal layer pattern arranged on the third insulation layer 013 are formed, in which the second gate metal layer pattern at least includes a second capacitor electrode, and a position of the second capacitive electrode corresponds to a position of the first capacitive electrode.

Then a fourth insulation layer is deposited, the fourth insulation layer is patterned by a patterning process, and a fourth insulation layer 014 pattern covering the second gate metal layer is formed, in which at least two first via holes are arranged on the fourth insulation layer 014, the fourth insulation layer 014, the third insulation layer 013 and the second insulation layer 012 in the two first via holes are etched away, and the surface of the first active layer is exposed.

Then a third metal film is deposited, the third metal film is patterned by a patterning process, and a source-drain metal layer pattern on the fourth insulation layer 014 is formed, in which the source-drain metal layer at least includes a first source electrode and a first drain electrode located in the display region. The first source electrode and the first drain electrode may be connected with the first active layer through the first via holes, respectively.

In the driving circuit of the red sub-pixel in the display region, the first active layer, the first gate electrode, the first source electrode and the first drain electrode may constitute a first transistor 210, and the first capacitor electrode and the second capacitor electrode may constitute a first storage capacitor 212. In the above manufacturing process, the driving circuit of the green sub-pixel and the driving circuit of the blue sub-pixel can be formed at the same time in one patterning process.

In some exemplary embodiments, the first insulation layer 011, the second insulation layer 012, the third insulation layer 013 and the fourth insulation layer 014 are made of any one selected from a group consisting of silicon oxide (SiOx), silicon nitride (SiNx) and silicon oxynitride (SiON), which can be a single layer, multiple layers or a composite layer. The first insulation layer 011 is called as a buffer layer, which is used to improve the water and oxygen resistance of the base substrate; the second insulation layer 012 and the third insulation layer 013 are called as gate insulation (GI) layers; and the fourth insulation layer 014 is called as an interlayer dielectric (ILD) layer. The first metal film, the second metal film and the third metal film are made of metal materials, such as any one or more of silver (Ag), copper (Cu), aluminum (Al), titanium (Ti) and molybdenum (Mo), or alloy materials of the above metals, such as aluminum neodymium alloy (AlNd) or Molybdenum Niobium Alloy (MoNb), which can be a single-layer structure, or a multi-layer composite structure, such as Ti/Al/Ti and so on. The active layer film adopts one or more materials of amorphous indium gallium zinc oxide (a-IGZO), zinc oxide nitride (ZnON), indium zinc tin oxide (IZTO), amorphous silicon (a-Si), polycrystalline silicon (p-Si), hexathiophene, and polythiophene, that is, the present disclosure is applicable to transistors manufactured based on oxide technology, silicon technology, and organic technology.

Step 3: forming a planarization layer on the base substrate on which the above-mentioned patterns are formed.

In some exemplary embodiments, a planarization thin film of organic material is coated on the base substrate 010 formed with the above-mentioned patterns, a planarization (PLN) layer 015 covering the entire base substrate 010 is formed, and a plurality of second via holes in the planarization layer 015 in the display region are formed by masking, exposing and developing processes. The parts of the planarization layers 015 in the plurality of second via holes are developed away, and surfaces of the first drain electrodes of the first transistors 210 of the driving circuits of the red sub-pixels, surfaces of the first drain electrodes of the first transistors of the driving circuits of the green sub-pixels, and surfaces of the first drain electrodes of the first transistors of the driving circuits of the blue color sub-pixels 03 are respectively exposed.

Step 4: forming a first electrode pattern on the base substrate on which the above-mentioned patterns are formed. In some examples, the first electrode is a reflective anode.

In some exemplary embodiments, a conductive thin film is deposited on the base substrate 010 formed with the above-mentioned patterns, and the conductive film is patterned by a patterning process, to form a first electrode pattern. The first anode 213 of the red sub-pixel is connected with the first drain electrode of the first transistor 210 through the second via hole, the second anode 223 of the green sub-pixel 2 is connected with the first drain electrode of the first transistor of the green sub-pixel through the second via hole, and the third anode 233 of the blue sub-pixel 23 is connected with the first drain electrode of the first transistor of the blue sub-pixel through the second via hole.

In some examples, the first electrode may be a metal material, such as any one or more selected from a group consisting of magnesium (Mg), silver (Ag), copper (Cu), aluminum (Al), titanium (Ti) and molybdenum (Mo), or alloy materials of the above metals, such as aluminum neodymium alloy (AlNd) or molybdenum niobium alloy (MoNb), which can be a single-layer structure, or a multi-layer composite structure, such as a multi-layer composite structure of Ti/Al/Ti, or may be a stack structure formed by metal material and transparent conductive material, such as a stack structure of ITO/Ag/ITO, Mo/AlNd/ITO and other reflective materials.

Step 5: forming a pixel definition layer (PDL) pattern on the base substrate on which the above-mentioned patterns are formed.

In some exemplary embodiments, a pixel definition film is coated on the base substrate 010 formed with the above-mentioned patterns, and a pixel definition layer pattern is formed by masking, exposing and developing processes. As shown in FIG 12, the pixel definition layer 30 of the display region includes a plurality of sub-pixel definition parts 302, a plurality of pixel openings 301 are formed between adjacent sub-pixel definition parts 302, the parts of the pixel definition layers 30 in the plurality of the pixel openings 301 are developed away, and at least part of the surfaces of the first anodes 213 of the red sub-pixels, at least part of the surfaces of the second anodes 223 of the green sub-pixels, and at least part of the surfaces of the third anodes 233 of the blue sub-pixels are exposed, respectively.

In some examples, the pixel definition layer 30 may be made of polyimide, acrylic, or polyethylene terephthalate, etc.

Step 6: forming a post spacer (PS) pattern on the base substrate on which the above-mentioned patterns are formed.

In some exemplary embodiments, an organic material thin film is coated on the base substrate 010 formed with the above-mentioned patterns, and a post spacer (PS) 34 pattern is formed by the masking, exposing and developing processes. The post spacer 34 may serve as a support layer, and is configured to support the high-precision mask (FMM) during the evaporation process. In some examples, along a row arrangement direction of the sub-pixels, a repeating unit is spaced between two adjacent spacer columns 34, for example, the post spacer 34 may be located between adjacent red sub-pixel and blue sub-pixel 03.

Step 7: sequentially forming an organic functional layer and a second electrode on the base substrate on which the above-mentioned patterns formed. In some examples, the second electrode is a transparent cathode. The light-emitting element can emit light from a side away from the base substrate 010 through the transparent cathode to realize top emission. In some examples, the organic functional layer of the light emitting element includes: a hole injection layer, a hole transport layer, a light emitting layer, and an electron transport layer.

In some exemplary embodiments, the hole injection layer 241 and the hole transport layer 242 are sequentially formed using an open mask by evaporation on the base substrate 010 on which the above-mentioned patterns are formed, then a blue light-emitting layer 236, a green light-emitting layer 216 and a red light-emitting layer 226 are sequentially formed using a FMM by evaporation, and then an electron transport layer 243, a cathode 244 and a light coupling layer 245 are sequentially formed using the open mask by evaporation. The hole injection layer 241, the hole transport layer 242, the electron transport layer 243 and the cathode 244 are all common layers of the plurality of the sub-pixels. In some examples, the organic functional layer may further include: a micro-cavity adjustment layer between the hole transport layer and the light emitting layer. For example, after the hole transport layer is formed, a blue micro-cavity adjusting layer, a blue light-emitting layer, a green micro-cavity adjusting layer, a green light-emitting layer, a red micro-cavity adjusting layer, and a red light-emitting layer are formed by successive evaporation by using the FMM.

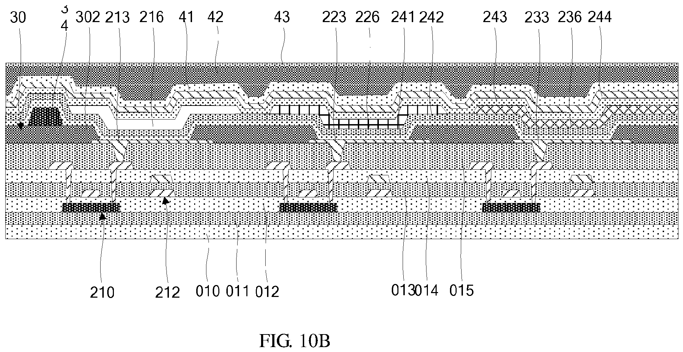

In some exemplary embodiments, as shown in FIG 10A, due to a limitation of a FMM opening, the adjacent blue light-emitting layer 236, the green light-emitting layer 216 and the red light-emitting layer 226 formed by evaporation may overlap. FIG 10B is a schematic diagram of another exemplary layer structure of a pixel array. It can be seen from FIG 10B, the adjacent blue light-emitting layer 236, the green light-emitting layer 216 and the red light-emitting layer 226 may not overlap, that is, by selecting FMMs with different opening sizes, the sizes of the formed light-emitting layers are also different. In some exemplary embodiments, the organic functional layer is formed in the sub-pixel region, to realize a connection between the organic functional layer and the anode. The cathode is formed on the pixel definition layer, and is connected with the organic functional layer.

In some exemplary embodiments, the cathode may adopt any one or more of magnesium (Mg), silver (Ag), aluminum (Al), or may adopt an alloy made of any one or more of the above-mentioned metals, or may adopt a transparent conductive material such as indium tin oxide (ITO), or the cathode is a multi-layer composite structure of metal and transparent conductive material.

In some exemplary embodiments, the light coupling layer may be formed on a side of the cathode 244 away from the base substrate 10, the light coupling layer may be a common layer of a plurality of sub-pixels. The light coupling layer can cooperate with the transparent cathode, and plays a role of increasing light output. For example, the material of the light coupling layer may adopt a semiconductor material. However, the embodiment does not limit this.

Step 8: forming an encapsulation layer on the base substrate on which the above-mentioned patterns are formed.

In some exemplary embodiments, forming an encapsulation layer on the base substrate 010 on which the above-mentioned patterns are formed, in which the encapsulation layer may include a first encapsulation layer 41, a second encapsulation layer 42 and a third encapsulation layer 43 that are stacked. The first encapsulation layer 41 adopts an inorganic material, and covers the cathode 244 in the display region. The second encapsulation layer 42 adopts an organic material. The third encapsulation layer 43 adopts an inorganic material, and covers both the first encapsulation layer 41 and the second encapsulation layer 42. However, the embodiment does not limit to this. In some examples, the encapsulation layer may adopt a five-layer structure of inorganic/organic/inorganic/organic/inorganic.

What are described above is related to only the illustrative embodiments of the present disclosure and not limitative to the protection scope of the present application. Therefore, the protection scope of the present application shall be defined by the accompanying claims.

## Claims

1. A display panel, comprising:
a base substrate, wherein a plurality of sub-pixels are arranged on the base substrate, at least part of the plurality of sub-pixels comprises a light-emitting layer;
at least two sub-pixels consecutively arranged among the plurality of sub-pixels constitute one sub-pixel group, in each sub-pixel group of at least part of the sub-pixel groups, the light-emitting layers of at least two consecutively arranged sub-pixels are made of a same material and constitute an integral structure; the at least part of the sub-pixel groups comprises at least two sub-pixel groups that respectively emit light of different colors.

2. The display panel according to claim 1, wherein a plurality of pixels are arranged on the base substrate, each pixel of the plurality of pixels comprises a plurality of the sub-pixels, the plurality of the sub-pixels of one of the pixels comprise:
a first sub-pixel, comprising a first light-emitting layer, wherein the first light-emitting layer emits a first color light;
a second sub-pixel, comprising a second light-emitting layer, wherein the second light-emitting layer emits a second color light; and
a third sub-pixel, comprising a third light-emitting layer, wherein the third light-emitting layer emits a third color light, color of the first color light, color of the second color light and color of the third color light are different from each other,
wherein at least two of the first sub-pixels are consecutively arranged to constitute one first sub-pixel group;
at least two of the second sub-pixels are consecutively arranged to constitute one second sub-pixel group;
at least two of the third sub-pixels are consecutively arranged to constitute one third sub-pixel group; and
the at least part of the sub-pixel groups comprises at least two selected from a group consisting of the first sub-pixel group, the second sub-pixel group, and the third sub-pixel group.

3. The display panel according to claim 2, wherein
in each first sub-pixel group of at least part of the first sub-pixel groups, the first light-emitting layers of the first sub-pixels that are consecutively arranged constitute an integral structure;
in each second sub-pixel group of at least part of the second sub-pixel groups, the second light-emitting layers of the second sub-pixels that are consecutively arranged constitute an integral structure; and
in each third sub-pixel group of at least part of the third sub-pixel groups, the third light-emitting layers of the third sub-pixels that are consecutively arranged constitute an integral structure.

4. The display panel according to claim 3, wherein in each first sub-pixel group of the at least part of the first sub-pixel groups, a planar shape of the integral structure constituted by the first light-emitting layers of the two consecutively arranged first sub-pixels is one selected from a group consisting of a hexagon, an octagon, an ellipse, a rhombus, and a fusiform; and/or
in each third sub-pixel group of the at least part of the third sub-pixel groups, a planar shape of the integral structure constituted by the third light-emitting layers of the two consecutively arranged third sub-pixels is one selected from the group consisting of a hexagon, an octagon, an ellipse, a rhombus, and a fusiform.

5. The display panel according to claim 2, wherein
in each first sub-pixel group of at least part of the first sub-pixel groups, the first light-emitting layers of the first sub-pixels that are consecutively arranged constitute an integral structure;
in each second sub-pixel group of at least part of the second sub-pixel groups, the second light-emitting layers of the second sub-pixels that are consecutively arranged do not constitute an integral structure; and
in each third sub-pixel group of at least part of the third sub-pixel groups, the third light-emitting layers of the third sub-pixels that are consecutively arranged constitute an integral structure.

6. The display panel according to claim 5, wherein an area of the second light-emitting layer of the second sub-pixel is greater than an area of the first light-emitting layer of the first sub-pixel, and is greater than an area of the third light-emitting layer of the third sub-pixel.

7. The display panel according to any one of claims 3 to 6, wherein a shorter bottom edge of the first light-emitting layer of the first sub-pixel and a shorter bottom edge of the third light-emitting layer of the third sub-pixel that is adjacent to the first sub-pixel are close to each other and opposite to each other.

8. The display panel according to any one of claims 3 to 7, further comprising:
a pixel definition layer, comprising a plurality of openings and a main body defining the plurality of openings, wherein the plurality of openings are in one-to-one correspondence with the plurality of sub-pixels;
in each sub-pixel group of the at least part of the sub-pixel groups, the light-emitting layer of each of the sub-pixels comprises an effective part in the corresponding opening among the openings of the pixel definition layer, and an edge part on the main body of the pixel definition layer.

9. The display panel according to claim 8, wherein a first distance between edges of effective parts of two consecutively arranged first sub-pixels in each of the first sub-pixel groups that are close to each other and opposite to each other, a second distance between edges of effective parts of two consecutively arranged second sub-pixels in each second sub-pixel groups that are close to each other and opposite to each other, and a third distance between edges of effective parts of two consecutively arranged third sub-pixels in each of the third sub-pixel groups that are close to each other and opposite to each other are basically equal.

10. The display panel according to claim 8 or 9, wherein the first distance, the second distance, and the third distance are respectively less than or equal to 8 µm.

11. The display panel according to any one of claims 8 to 10, wherein a planar shape of the effective part of the first sub-pixel, a planar shape of the effective part of the second sub-pixel, and a planar shape of the effective part of the third sub-pixel are respectively consistent with an planar shape of the entire first light-emitting layer, an planar shape of the entire second light-emitting layer, and an planar shape of the entire third light-emitting layer.

12. The display panel according to any one of claims 8 to 11, wherein in each of the at least part of the first sub-pixel groups, a planar shape of each effective part of the consecutively arranged first sub-pixels is a trapezoid, and longer bottom edges of the effective parts of the two consecutively arranged first light-emitting layers are close to each other and opposite to each other; and/or
in each of the at least part of the third sub-pixel groups, a planar shape of each effective part of the consecutively arranged third sub-pixels is a trapezoid, and longer bottom edges of the effective parts of the two consecutively arranged third light-emitting layers are close to each other and opposite to each other.

13. The display panel according to any one of claims 8 to 11, wherein a planar shape of the effective part of the first light-emitting layer, a planar shape of the effective part of the second light-emitting layer, and a planar shape of the effective part of the third light-emitting layer are all rectangular.

14. The display panel according to any one of claims 8 to 13, wherein in each sub-pixel group of the at least part of the sub-pixel groups, edges of the effective part are in one-to-one correspondence with edges of an outer contour of the edge part, each pair of mutually corresponding edges of the effective part and the outer contour of the edge part are close to and opposite to each other, and a distance between each pair of mutually corresponding edges of the effective part and the outer contour of the edge part is less than or equal to 9 µm.

15. The display panel according to claim 14, wherein in the first sub-pixel, in the second sub-pixel, and in the third sub-pixel, distances between each pair of mutually corresponding edges of the effective part and the outer contour of the edge part are same.

16. The display panel according to any one of claims 8 to 15, wherein a pixel array comprises a plurality of sub-pixel rows extending in a first direction, a plurality of first sub-pixel columns extending in a second direction, and a plurality of second sub-pixel columns extending in the second direction, each of the second sub-pixel columns is between the consecutively arranged first sub-pixel columns, the second direction intersects the first direction;
in each of the first sub-pixel columns, the first sub-pixel groups and the third sub-pixel groups are alternately arranged; in each of the second sub-pixel columns, a plurality of the second sub-pixel groups are arranged in sequence; and
the second light-emitting layer of one of the second sub-pixel groups and the second light-emitting layer of another one of the second sub-pixel groups consecutively arranged with the one of the second sub-pixel groups in the second sub-pixel column do not constitute an integral structure.

17. The display panel according to claim 16, wherein a gap is between the second light-emitting layer of the one of the second sub-pixel groups and the second light-emitting layer of the another one of the second sub-pixel groups consecutively arranged with the one of the second sub-pixel groups; and
a distance between two adjacent effective parts in the second light-emitting layers constituting the integral structure in the second sub-pixel group is smaller than a distance between the effective parts of, two adjacent second light-emitting layers that are spaced apart by the gap between each other.

18. The display panel according to claim 16 or 17, wherein a ratio of an area of the effective part of each of the first sub-pixels to an area of an entirety of the light-emitting layer of each of the first sub-pixels is 17%; a ratio of an area of the effective part of each of the second sub-pixels to an area of an entirety of the light-emitting layer of each of the second sub-pixels is 21%; and a ratio of an area of the effective part of each of the third sub-pixels to an area of an entirety of the light-emitting layer of each of the third sub-pixels is 30%.

19. The display panel according to any one of claims 16 to 18, wherein one of the first sub-pixels and one of the third sub-pixels adjacent to each other in one of the first sub-pixel columns, and one of the second sub-pixels in the second sub-pixel column adjacent to the one of the first sub-pixel columns constitute one pixel; or,
one of the first sub-pixels, one of the second sub-pixels, and one of the third sub-pixels that are respectively located in the first sub-pixel group, the second sub-pixel group and the third sub-pixel group that are consecutively arranged in the first direction constitute one pixel.

20. The display panel according to any one of claims 16 to 19, wherein the plurality of pixels are arranged periodically in the first direction and the second direction, respectively;
in one of the pixels, the first sub-pixel, the second sub-pixel, and the third sub-pixel are not aligned in the second direction, and an edge of the second sub-pixel close to the first sub-pixel and the third sub-pixel overlaps with both an edge of the first sub-pixel and an edge of the third sub-pixel that are close to the second sub-pixel.

21. The display panel according to any one of claims 16 to 20, wherein a plurality of the second sub-pixels in a same row overlap in the second direction, and a plurality of second sub-pixels located in a same column overlap in the first direction.

22. The display panel according to any one of claims 16 to 21, wherein an included angle is with between a direction, of a longest dimension of the effective part of at least one selected from a group consisting of the first sub-pixel, the second sub-pixel, and the third sub-pixel, and the first direction or the second direction, and the included angle is greater than 0 and less than or equal to 45 degrees.

23. The display panel according to any one of claims 16 to 22, wherein a length of the effective part of the second sub-pixel in the second direction is greater than a length of the effective part of the first sub-pixel in the second direction, and is greater than a length of the effective part of the third sub-pixel in the second direction.

24. The display panel according to any one of claims 16 to 23, wherein in each of the first sub-pixel groups, the effective parts of the first light-emitting layers of the two consecutively arranged first sub-pixels are symmetrical with respect to a first symmetry axis extending along the first direction; and/or
in each of the second sub-pixel groups, the effective parts of the second light-emitting layers of the two consecutively arranged second sub-pixels are symmetrical with respect to a second symmetry axis extending along the first direction; and / or
in each of the third sub-pixel groups, the effective parts of the third light-emitting layers of the two consecutively arranged third sub-pixels are symmetrical with respect to a third symmetry axis extending along the first direction.

25. The display panel according to any one of claims 16 to 24, wherein geometric centers of planar shapes of the first sub-pixel group, the second sub-pixel group, and the third sub-pixel group that are arranged in the first direction and located in a same row are substantially located on a same straight line extending along the first direction.

26. The display panel according to any one of claims 16 to 25, wherein in each of the first sub-pixel groups, the effective part of each of the first sub-pixels comprises a near edge close to the first symmetry axis and a far edge away from the first symmetry axis, a length of the near edge of the effective part of each of the first sub-pixels is greater than a length of the far edge of each of the first sub-pixels; and/or
in each of the third sub-pixel groups, the effective part of each of the third sub-pixels comprises a near edge close to the third symmetry axis and a far edge away from the third symmetry axis, and a length of the near edge of the effective part of each of the third sub-pixels is greater than a length of the far edge of the effective part of each of the third sub-pixels.

27. The display panel according to claim 26, wherein at least two selected from a group consisting of a distance from the near edge of the effective part of each of the first sub-pixels of each of the first sub-pixel groups to the second symmetry axis, a distance from the near edge of the effective part of each of the second sub-pixels of each of the second sub-pixel groups to the second symmetry axis, and a distance from the near edge of the effective part of each of the third sub-pixels of each of the third sub-pixel groups to the third symmetry axis are substantially equal.

28. The display panel according to any one of claims 16 to 27, wherein the first direction is a width direction of each of the sub-pixels, the effective part of each of the second sub-pixels is provided with a first width, a second width, and a third width that are sequentially away from the second symmetry axis in the first direction, the second width is greater than the first width, and the third width is greater than the first width.

29. The display panel according to any one of claims 16 to 28, wherein the first direction is a width direction of each of the sub-pixels, the second direction is a length direction of each of the sub-pixels;
in one of the pixels, a ratio of a length of the effective part of the second sub-pixel in the length direction to a width of the effective part of the second sub-pixel in the width direction is greater than a ratio of a length of the effective part of the third sub-pixel in the length direction to a width of the effective part of the third sub-pixel in the width direction, and is greater than a ratio of a length of the effective part of the first sub-pixel in the length direction to a width of the effective part of the first sub-pixel in the width direction.

30. The display panel according to claim 29, wherein the width of the effective part of the second sub-pixel in the width direction is smaller than the width of the effective part of the first sub-pixel in the width direction, and is smaller than the width of the effective part of the third sub-pixel in the width direction.

31. The display panel according to claim 29 or 30, wherein a length of the second sub-pixel in the length direction is greater than a length of the first sub-pixel in the length direction, and is greater than a length of the third sub-pixel in the length direction.

32. The display panel according to any one of claims 29 to 31, wherein the ratio of the length of the effective part of the first sub-pixel to the width of the effective part of the first sub-pixel ranges from 1:2.5 to 1:1, the ratio of the length of the effective part of the second sub-pixel to the width of the effective part of the second sub-pixel ranges from 9:1 to 2:1, and the ratio of the length of the effective part of the third sub-pixel to the width of the effective part of the third sub-pixel ranges from 3:1 to 1:1.

33. The display panel according to any one of claims 16 to 32, wherein a planar shape of the effective part of the second light-emitting layer is a polygon, a planar shape of the effective part of the second light-emitting layer comprises a first parallel edge and a second parallel edge, the first parallel edge is parallel to at least one edge of the effective part of the first light-emitting layer adjacent to the second light-emitting layer, and the second parallel edge is parallel to at least one edge of the effective part of the third light-emitting layer adjacent to the second light-emitting layer.

34. The display panel according to any one of claims 16 to 33, wherein the effective part of the second light-emitting layer has a symmetry axis in a same direction as a symmetry axis of the effective part of the first light-emitting layer and a symmetry axis of the effective part of the third light-emitting layer, or the effective part of the second light-emitting layer does not have a symmetry axis in a same direction as a symmetry axis of the effective part of the first light-emitting layer and a symmetry axis of the effective part of the third light-emitting layer.

35. The display panel according to any one of claims 16 to 34, wherein in the first direction, the light-emitting layer of the second sub-pixel group is in contact with the light-emitting layer of the first sub-pixel group and the light-emitting layer of the third sub-pixel group adjacent to the second sub-pixel group respectively; and in the second direction, the light-emitting layer of the first sub-pixel group is in contact with the light-emitting layer of the third sub-pixel group adjacent to the second sub-pixel group.

36. The display panel according to claim 35, wherein in at least one of the second sub-pixel groups, a planar shape of the integral structure constituted by the second light-emitting layers of two consecutively arranged second sub-pixels has a first size in the first direction, a second size in the first direction, and a third size in the first direction, the first size, the second size, and the third size are arranged in sequence in the second direction, the first size is greater than the second size, the third size is greater than the second size, and a maximum length in the second direction of the planar shape of the integral structure constituted by the second light-emitting layers of the two consecutively arranged second sub-pixels is greater than a maximum width in the first direction of the planar shape of the integral structure constituted by the second light-emitting layers of the two consecutively arranged second sub-pixels.

37. A display device, comprising the display panel according to any one of claims 1 to 36.

38. A manufacturing method of a display panel, comprising:
providing a base substrate; and
forming a plurality of sub-pixels on the base substrate, wherein at least part of the plurality of sub-pixels comprises a light-emitting layer,
wherein a mask is used to form the light-emitting layers of the plurality of sub-pixels through a patterning process, the mask comprises a plurality of mask openings;
at least two sub-pixels arranged consecutively among the plurality of sub-pixels constitute one sub-pixel group, in the patterning process, the light-emitting layer of each sub-pixel group in at least part of the sub-pixel groups is formed by using one same mask opening among the plurality of mask openings and is made of a same material; and the at least part of the sub-pixel groups comprises at least two sub-pixel groups that respectively emit light of different colors.
